(19) Europäisches Patentamt / European Patent Office / Office européen des brevets

(11) **EP 4 497 801 A1**

(12) **EUROPEAN PATENT APPLICATION**

(43) Date of publication:
**29.01.2025   Bulletin 2025/05**

(21) Application number: **24190854.0**

(22) Date of filing: **25.07.2024**

(51) International Patent Classification (IPC):
*C09K 11/02* (2006.01)     *C09K 11/88* (2006.01)

(52) Cooperative Patent Classification (CPC):
**C09K 11/883; C09K 11/02; C09K 11/025**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.07.2023   KR 20230097055**

(71) Applicant: **Samsung Electronics Co., Ltd.
Suwon-si, Gyeonggi-do 16677 (KR)**

(72) Inventors:
• **MIN, Ji Hyun
Suwon-si 16678 (KR)**
• **YOON, Daeun
Suwon-si 16678 (KR)**
• **YOON, Won Sik
Suwon-si 16678 (KR)**
• **LEE, Jae Yong
Suwon-si 16678 (KR)**
• **CHANG, Hogeun
Suwon-si 16678 (KR)**
• **HA, Hyundong
Suwon-si 16678 (KR)**
• **HAN, Yong Seok
Suwon-si 16678 (KR)**

(74) Representative: **Elkington and Fife LLP
Prospect House
8 Pembroke Road
Sevenoaks, Kent TN13 1XR (GB)**

(54) **SEMICONDUCTOR NANOPARTICLE, PRODUCTION METHOD THEREOF, AND ELECTROLUMINESCENT DEVICE AND DISPLAY DEVICE INCLUDING THE SAME**

(57)    A semiconductor nanoparticle, a method of preparing the semiconductor nanoparticle, and an electroluminescent device including the semiconductor nanoparticle. The method of preparing the semiconductor nanoparticle includes contacting a zinc precursor and a sulfur precursor in the presence of a first particle at a predetermined temperature to form a semiconductor nanocrystal layer containing zinc sulfide on the first particle, wherein the first particle includes a Group II-VI compound including zinc, selenium, and, optionally, tellurium, or the first particle includes a Group III-V compound including indium and phosphorus. The predetermined temperature includes (e.g., is) a temperature (e.g., a reaction temperature) of greater than 300 °C and less than or equal to about 380 °C, and the sulfur precursor includes a thiol compound of C3 (e.g. C9) to C50 or a combination thereof.

FIG. 2

EP 4 497 801 A1

**Description**

FIELD OF THE INVENTION

A production method of a semiconductor nanoparticle, the semiconductor nanoparticle produced from the method, and a device (e.g., an electroluminescent device) and a display device including the semiconductor nanoparticle.

BACKGROUND OF THE INVENTION

A semiconductor nanoparticle (e.g., a semiconductor nanocrystal particle) may emit light. For example, a quantum dot including a semiconductor nanocrystal may exhibit a quantum confinement effect, and light emission from the semiconductor nanoparticle may occur when an electron in an excited state as a result of light excitation or an applied voltage transits from a conduction band to a valence band. The semiconductor nanoparticle may be configured to emit light of a desired wavelength region by adjusting size and/or composition of the semiconductor nanoparticle.

The semiconductor nanoparticle may be used in a light-emitting device (e.g., an electroluminescent device) and a display device including the semiconductor nanoparticle.

SUMMARY OF THE INVENTION

An embodiment provides a preparation method of a semiconductor nanoparticle.

An embodiment provides a semiconductor nanoparticle that can be prepared by the method of preparation.

An embodiment provides a luminescent device that is configured to emit light, with or without an additional light source, for example, by applying a voltage to the semiconductor nanoparticle.

An embodiment provides a display device (e.g., a quantum dot-light-emitting diode (QD-LED) display) that includes a light-emitting material having a nanostructure (e.g., a nanoparticle such as the semiconductor nanoparticle) in a configuration of a blue pixel, a red pixel and/or a green pixel.

An embodiment provides a semiconductor nanoparticle that may be included in the luminescent device of an embodiment.

An embodiment provides a display apparatus including the semiconductor nanoparticle.

In an embodiment, a method for preparing a semiconductor nanoparticle includes contacting a zinc precursor and a sulfur precursor in the presence of a first particle at a predetermined temperature to form a semiconductor nanocrystal layer containing a zinc sulfide on the first particle, for example, the contacting resulting in a reaction between the zinc precursor and the sulfur precursor. The first particle includes a Group II-VI compound including zinc and selenium. The Group II-VI compound (or the first particle) may further include tellurium (or a Group II-VI compound including zinc, selenium, and tellurium). The predetermined temperature includes a temperature (e.g., a reaction temperature) of greater than or equal to about 300 °C and less than or equal to about 380 °C.

The sulfur precursor includes a thiol compound (e.g. a monothiol compound) of C3 (e.g. C8 or C9) to C50 (or C10-C24 or C12-C18) or a combination thereof. The sulfur precursor (or the thiol compound) may include (a thiol compound having) a C3 to C30 (C8-C12 or C14) branched hydrocarbon group.

The sulfur precursor may include or may not include a sulfur-trioctylamine (S-TOA), a sulfur-trioctylphosphine (S-TOP), a sulfur-octadecene (S-ODE), a sulfur-tributylphosphine (S-TBP), a sulfur-triphenylphosphine (S-TPP), a bis(trialkylsilyl) sulfide (e.g., bis(trimethylsilyl) sulfide), a trialkyl silyl alkyl sulfide (e.g., trimethylsilyl methylsulfide), or a combination thereof.

The sulfur precursor may not include a sulfur-hydrocarbon solvent adduct.

The first particle may further include a Group III-V compound. The Group III-V compound may include indium and phosphorus.

The first particle or the semiconductor nanoparticle may include a first semiconductor nanocrystal and a second semiconductor nanocrystal. The first semiconductor nanocrystal may include a Group II-VI compound including zinc, selenium, and tellurium; or a Group III-V compound including indium and phosphorus. The second semiconductor nanocrystal may include a Group II-VI compound including zinc and selenium.

In an embodiment, the first semiconductor nanocrystal may include a Group II-VI compound including zinc, selenium, and tellurium, and the second semiconductor nanocrystal may include a Group II-VI compound including zinc and selenium. In an embodiment, the first semiconductor nanocrystal may include a Group III-V compound including indium and phosphorus, and the second semiconductor nanocrystal may include a Group II-VI compound including zinc and selenium.

The second semiconductor nanocrystal may be disposed between the first semiconductor nanocrystal (e.g., a first semiconductor nanocrystal layer) and the semiconductor nanocrystal layer.

The method may further include adding the first particle, the zinc precursor, and the sulfur precursor to a reaction medium including an organic solvent at a first temperature.

The reaction medium can be pre-treated at a temperature of from about 80 °C to about 180 °C under vacuum.

Prior to being added to the reaction medium, the first particle may be washed with an organic solvent and then be dispersed in a dispersing solvent.

The first temperature may be greater than or equal to about 180 °C, or greater than or equal to about 200 °C. The first temperature may be less than or equal to the predetermined temperature (e.g., a temperature for a reaction between the sulfur precursor and the zinc precursor). The first temperature may be less than or equal to about 340 °C, less than or equal to about 320 °C, less than or equal to about 319 °C, or less than or equal to about 280 °C.

The predetermined temperature (or the reaction temperature) may be greater than or equal to about 315 °C and less than or equal to about 319 °C.

The predetermined temperature (or the reaction temperature) may be greater than or equal to about 336 °C and less than or equal to about 360 °C.

The sulfur precursor may include a compound (a thiol compound) (for example, represented by R-SH, wherein R is a substituted or unsubstituted C3 (e.g., C8 or C9) to C50 aliphatic linear or branched hydrocarbon group, for example, an alkyl, alkenyl, or alkynyl). In an embodiment, R of the thiol compound may be a C8-C24 branched-chain aliphatic hydrocarbon group.

The sulfur precursor may include octane thiol, ethylhexane thiol (e.g., 2-ethylhexane thiol), decane thiol, undecane thiol, dodecane thiol, tetradecane thiol, hexadecane thiol, octadecane thiol, or a mixture thereof.

The zinc precursor may include a zinc carboxylate having a substituted or unsubstituted C1 to C60, or C5 to C40 aliphatic hydrocarbon group.

The zinc precursor may include a compound represented by Chemical Formula 1:

Chemical Formula 1          ACOO-Zn-OOCB

In Chemical Formula 1, A and B are the same or different, and each independently a substituted or unsubstituted, linear or branched, C1 to C60 aliphatic hydrocarbon group (e.g., an alkyl, an alkenyl or an alkynyl group) or a substituted or unsubstituted C3-C50 or C6-C30 aromatic hydrocarbon group.

In Chemical Formula 1, A and B are the same or different, and each independently a substituted or unsubstituted, C1-C11 or C4-C8, linear or branched, aliphatic hydrocarbon group, a substituted or unsubstituted C12-C60 or C16-24, linear or branched, aliphatic hydrocarbon group, or a combination thereof.

In Chemical Formula 1, A and B are the same or different, and each independently may be an ethylhexyl group, a methylbutyl group (e.g., 2- methylbutyl group, 3- methylbutyl group), a hexyldecyl group (2- hexyldecyl group), an oleyl group, a myristyl group, a stearyl group, a lauryl group, or a combination thereof.

In an embodiment, the semiconductor nanoparticle comprises a first organic ligand including a carboxylate moiety of C12 or higher (e.g., derived from a zinc carboxylate such as a zinc oleate) and a second organic ligand including a thiolate moiety (for example, derived from the thiol compound), and in a GC-MS (Gas Chromatography-Mass Spectrometry) analysis, a peak area of the second organic ligand may be greater than or equal to about 0.01%, greater than or equal to about 0.1%, greater than or equal to about 0.5% and less than or equal to about 17% of a total area of the peaks of the first organic ligand and the second organic ligand.

In an embodiment, in a thermogravimetric analysis, the semiconductor nanoparticle may exhibit a residue weight that is greater than or equal to about 85% by weight, greater than or equal to about 86% by weight, or greater than or equal to about 87% by weight of a total weight of the semiconductor nanoparticle. In an embodiment, as determined by a thermogravimetric analysis, the semiconductor nanoparticle may exhibit an organic matter content of less than or equal to about 14% by weight, less than or equal to about 13% by weight, or less than or equal to about 12% by weight. As determined by a thermogravimetric analysis, a differential thermogravimetric curve of the semiconductor nanoparticle may exhibit a peak at a temperature between about 200 °C and about 300 °C. The differential thermogravimetric curve of the semiconductor nanoparticle may further exhibit a peak at a temperature between about 300 °C or about 400 °C and about 500 °C.

The semiconductor nanoparticle may not include cadmium.

In an embodiment, a semiconductor nanoparticle includes zinc, selenium, tellurium, and sulfur, and does not include cadmium. The semiconductor nanoparticle is configured to emit blue light, the semiconductor nanoparticle has an absolute quantum yield of greater than or equal to about 90%, and in the semiconductor nanoparticle, a molar ratio of zinc to selenium (Zn:Se) is greater than or equal to about 1:1 and less than or equal to about 3:1, or less than or equal to about 2.3:1, and a mole ratio of sulfur to tellurium (S:Te) is greater than or equal to about 10:1, or greater than 73:1 and less than or equal to about 180:1. The semiconductor nanoparticle may include a semiconductor nanocrystal layer including a zinc sulfide.

The semiconductor nanoparticle may include a first semiconductor nanocrystal and a second semiconductor nanocrystal, the first semiconductor nanocrystal may include a Group II-VI compound including zinc, selenium, and tellurium, and the second semiconductor nanocrystal may include a Group II-VI compound including zinc and selenium. The second semiconductor nanocrystal may be disposed between the first semiconductor nanocrystal (e.g., a first semiconductor nanocrystal layer) and the semiconductor nanocrystal layer. Details of the semiconductor nanoparticle are the same as described herein.

The blue light may have a peak emission wavelength of greater than or equal to about 440 nm, or greater than or equal to about 450 nm and less than about 480 nm, less than or equal to about 479 nm.

The peak emission wavelength may be greater than or equal to about 455 nm, and less than or equal to about 475 nm, greater than or equal to about 460 nm and less than or equal to about 473 nm, greater than or equal to about 466 nm and less than or equal to about 472 nm, greater than or equal to about 468 nm and less than or equal to about 470 nm, or a combination thereof.

The absolute quantum yield may be greater than or equal to about 91 % and less than or equal to about 99%, greater than or equal to about 93% and less than or equal to about 98%, greater than or equal to about 95% and less than or equal to about 96%, or any combination of the listed greater than and less than values.

The semiconductor nanoparticle may have a size or an average size (hereinafter, "size") of greater than or equal to about 7 nm, greater than or equal to about 8 nm, greater than or equal to about 9 nm, or greater than or equal to about 10 nm and less than or equal to about 13 nm, less than or equal to about 11 nm, or less than or equal to about 10.2 nm.

The semiconductor nanoparticle may have a solidity or an average solidity (herein, simply referred to as "solidity") of greater than or equal to about 0.975.

In the semiconductor nanoparticle, a mole ratio of zinc to selenium (Zn:Se) may be less than or equal to about 2.5:1, less than or equal to about 2.1:1, less than or equal to about 2:1, less than or equal to about 1.9:1, and greater than or equal to about 1.2:1, greater than or equal to about 1.5:1, or greater than or equal to about 1.7:1.

In the semiconductor nanoparticle, a mole ratio of sulfur to tellurium (S:Te) may be greater than or equal to about 50:1, or greater than or equal to about 65:1.

In the semiconductor nanoparticle, a mole ratio of sulfur to tellurium (S:Te) may less than or equal to about 200:1, less than or equal to about 180:1, less than or equal to about 160:1, or less than or equal to about 110:1.

In the semiconductor nanoparticle, a mole ratio of sulfur to a sum of sulfur and selenium (S:(S+Se)) may be greater than or equal to about 0.3:1 and less than or equal to about 0.5:1.

In an embodiment, a semiconductor nanoparticle includes indium, phosphorus, zinc, selenium, and sulfur, the semiconductor nanoparticle does not include cadmium, and the semiconductor nanoparticle includes a semiconductor nanocrystal layer including a zinc sulfide, and the semiconductor nanoparticle may be configured to emit green light.

The semiconductor nanoparticle may include a first semiconductor nanocrystal and a second semiconductor nanocrystal. The first semiconductor nanocrystal may include a Group III-V compound including indium and phosphorus. The second semiconductor nanocrystal may include a Group II-VI compound including zinc and selenium. The second semiconductor nanocrystal may be disposed between the first semiconductor nanocrystal (e.g., a first semiconductor nanocrystal layer) and the semiconductor nanocrystal layer. Details of the semiconductor nanoparticle are the same as described herein.

The green light may have a peak emission wavelength of greater than or equal to about 480 nm and less than or equal to about 580 nm.

The semiconductor nanoparticles may have an absolute quantum yield that is greater than or equal to about 90%, greater than or equal to about 91% and less than or equal to about 99%, greater than or equal to about 93% and less than or equal to about 98%, greater than or equal to about 95% and less than or equal to about 96%, or a combination thereof.

In the semiconductor nanoparticle, a mole ratio of zinc to indium (Zn:In) may be greater than or equal to about 60:1 and less than or equal to about 250:1, greater than or equal to about 70:1 and less than or equal to about 120:1, or a combination thereof.

In the semiconductor nanoparticle, a mole ratio of indium to a sum of selenium and sulfur (In:(Se+S)) may be greater than or equal to about 0.0001:1 and less than or equal to about 0.03:1.

In the semiconductor nanoparticle, a mole ratio of sulfur to selenium (S:Se) may be less than or equal to about 0.5:1.

The semiconductor nanoparticle may have a size or an average size that is greater than or equal to about 7.5 nm and less than or equal to about 20 nm, greater than or equal to about 8 nm and less than or equal to about 10 nm, or a combination thereof, and optionally, the semiconductor nanoparticle may have a particle size distribution showing a standard deviation of less than or equal to about 10% of an average particle size.

In an embodiment, an electroluminescent device includes a first electrode and a second electrode, for example, spaced apart from each other (e.g., each electrode having a surface opposite the other), and a light-emitting layer disposed between the first electrode and the second electrode, wherein the light-emitting layer includes a semiconductor nanoparticle.

In an embodiment, the light-emitting layer (or the semiconductor nanoparticle) may be configured to emit blue light. In an embodiment, the light-emitting layer (or the semiconductor nanoparticle) may be configured to emit green light.

In the light emitting layer, an amount of chlorine may be less than or equal to about 1.4 atomic %, less than or equal to about 1.2 atomic %, or less than or equal to about 0.8 atomic %, based on the total elements of the light emitting layer.

The electroluminescent device may have a maximum external quantum efficiency (EQE) of greater than or equal to about 8%, greater than or equal to about 10%, greater than or equal to about 11% or greater than or equal to about 12%. The electroluminescent device may have a maximum luminance of greater than or equal to about 60,000 candela per square meter ($cd/m^2$), greater than or equal to about 80,000 $cd/m^2$, greater than or equal to about 90,000 $cd/m^2$, or greater than or equal to about 100,000 $cd/m^2$.

The light-emitting layer may be configured to emit blue light, and the electroluminescent device, operated at an initial luminance of 650 $cd/m^2$ (nits), may have a T90 that is greater than or equal to about 20 hours, greater than or equal to about 25 hours, greater than or equal to about 30 hours, or greater than or equal to about 40 hours.

The electroluminescent device, operated at an initial luminance of 650 nits, may have a T50 that is greater than or equal to about 70 hours, greater than or equal to about 80 hours, greater than or equal to about 90 hours, or greater than or equal to about 170 hours.

In an embodiment, the light-emitting layer may be configured to emit green light, and the electroluminescent device, at an initial operation luminance of 2700 nits, may exhibit a T90 that is greater than or equal to about 60 hours, greater than or equal to about 80 hours, or greater than or equal to about 120 hours; or the electroluminescent device, at an initial operation luminance of 1000 nits, may exhibit a T90 of greater than or equal to about 500 hours.

In an embodiment, a photoluminescent device includes a light-emitting layer including the semiconductor nanoparticle; and a light source, and the light source is configured to provide incident light to the light-emitting layer. In the light-emitting layer, the semiconductor nanoparticle may be dispersed in a matrix (e.g., a polymer matrix including an insulating polymer).

In an embodiment, a display device includes the semiconductor nanoparticle, the electroluminescent device, the photoluminescent device, or a combination thereof. The display device may include or may be included in a VR device, an AR device, a mobile terminal device, a monitor, a computer (e.g., a laptop or a tablet), a television, an electronic sign, a camera, or an electronic component for a vehicle.

According to the manufacturing method of an embodiment, on a nanoparticle including a core including a Group III-V compound or a Group II-VI compound, and a (semiconductor nanocrystal) layer including a Group II-VI based a zinc chalcogenide, a semiconductor nanocrystal layer including a zinc sulfide can be readily formed with an enhanced efficiency or an enhanced rate. For example, the semiconductor nanoparticle has an increased particle size, and the formed semiconductor nanocrystal layer can exhibit an improved coating quality. A semiconductor nanoparticle prepared according to a method of an embodiment can exhibit an improved shape parameter. In an embodiment, the semiconductor nanoparticle may include a limited amount of a thiol-derived ligand and, when the semiconductor nanoparticle is applied to an electronic device, e.g., an electroluminescent device, the electronic device may exhibit an enhanced device performance (e.g., an improved light emitting efficiency and/or an increased lifetime).

The semiconductor nanoparticle may be used in various display devices and biological labeling (e.g., biosensors or bio-imaging), photodetectors, solar cells, or hybrid composites. In an embodiment, the light-emitting device or the electroluminescent device may contribute to the realization of, e.g., providing, improved display quality when being applied to, e.g., used in, a display device.

BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a flow diagram illustrating a process for preparing a semiconductor nanoparticle according to an embodiment.
FIG. 2 is a schematic cross-sectional representation of an embodiment of a light-emitting device.
FIG. 3 is a schematic cross-sectional representation of an embodiment of a light-emitting device.
FIG. 4 is a schematic cross-sectional representation of an embodiment of a light-emitting device.
FIG. 5A illustrates the results of a GC-MS analysis for the semiconductor nanoparticles prepared in Synthesis Example 1-1 (A), Synthesis Example 1-2 (B), and Comparative Synthesis Example 2-1 (C).
FIG. 5B illustrates the results of a GC-MS analysis for the semiconductor nanoparticle prepared in Comparative Synthesis Example 3.

DETAILED DESCRIPTION OF THE EMBODIMENTS

Advantages and characteristics of this disclosure, and a method for achieving the same, will become evident referring to the following example embodiments together with the drawings attached hereto. However, this invention may, be embodied in many different forms, the embodiments should not be construed as being limited to the embodiments set forth herein. Rather, these embodiments are provided so that this disclosure will be thorough and complete, and will fully convey the scope of the invention to those skilled in the art.

If not defined otherwise, all terms in the specification (including technical and scientific terms) are used as commonly understood by a person of ordinary skilled in the art. It will be further understood that terms, such as those terms defined in a common dictionary should be interpreted as having a meaning that is consistent with their meaning in the context of the relevant art, and may not be interpreted ideally or exaggeratedly unless clearly defined. The terminology used herein is for the purpose of describing particular embodiments and is not intended to be limiting.

As used herein, the singular forms "a," "an," and "the" are intended to include the plural forms, including "at least one," unless the content clearly indicates otherwise. For example, "an element" has the same meaning as "at least one element," unless the context clearly indicates otherwise. Accordingly, as used herein, the wording "a nanoparticle" may refer to a single nanoparticle or a plurality of nanoparticles. For example, the wording "a semiconductor nanoparticle" may refer to a single semiconductor nanoparticle or a plurality of semiconductor nanoparticles. "At least one" is not to be construed as limiting "a" or "an." "Or" means "and/or." As used herein, the term "and/or" includes any and all combinations of one or more of the associated listed items.

It will be further understood that the terms "comprise" and variations such as "comprises," "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. In order to clearly illustrate the embodiments in the drawings, some portions not really relevant to the explanation may be omitted.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

As used herein, the term "cross-sectional" means a case in which a cross-section of a given object is cut, for example, in a substantially vertical direction and is viewed laterally.

Hereinafter, values of a work function, a conduction band, or a lowest unoccupied molecular orbital (LUMO) (or valence band, or a highest occupied molecular orbital (HOMO)) energy level is expressed as an absolute value from a vacuum level. In addition, when the work function or the energy level is referred to be "deep," "high" or "large," the work function or the energy level has a large absolute value based on "0 electron volts (eV)" of the vacuum level, while when the work function or the energy level is referred to be "shallow," "low," or "small," the work function or energy level has a small absolute value based on "0 eV" of the vacuum level.

As used herein, the term "Group" may refer to a group of Periodic Table.

As used herein, "Group III" refers to Group IIIA and Group IIIB, and examples of a Group IIIA metal may be Al, In, Ga, or Tl, and examples of Group IIIB may be scandium, or yttrium, but are not limited thereto.

As used herein, "Group V" includes Group VA and includes nitrogen, phosphorus, arsenic, antimony, or bismuth, but is not limited thereto.

As used herein, an average may be mean or median. In an embodiment, the average may be a mean value.

As used herein, when a definition is not otherwise provided, "substituted" refers to replacement of hydrogen of a compound, a group, or moiety by a substituent such as a C1 to C30 alkyl group, a C2 to C30 alkenyl group, a C2 to C30 alkynyl group, a C2 to C30 epoxy group, a C2 to C30 alkylester group, a C3 to C30 alkenylester group (e.g., acrylate group, methacrylate group), a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR', wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, when a definition is not otherwise provided, "hydrocarbon" and "hydrocarbon group" refers to a compound or a group including carbon and hydrogen (e.g., alkyl, alkenyl, alkynyl, or aryl group). The hydrocarbon group may be a group having a monovalence or more formed by removal of a, e.g., greater than or equal to about one hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon compound or hydrocarbon group (alkyl, alkenyl, alkynyl, or aryl) may have 1 to 60, 2 to 32, 3 to 24, or 4 to 12 carbon atoms.

As used herein, when a definition is not otherwise provided, "aliphatic" refers to a saturated or unsaturated linear or branched hydrocarbon or hydrocarbon group. An aliphatic group may be an alkyl, alkenyl, or alkynyl group, for example.

As used herein, when a definition is not otherwise provided, "alkyl" refers to a linear or branched saturated monovalent hydrocarbon group (methyl, ethyl hexyl, etc.).

As used herein, when a definition is not otherwise provided, "alkenyl" refers to a linear or branched monovalent hydrocarbon group having a carbon-carbon double bond.

As used herein, when a definition is not otherwise provided, "alkynyl" refers to a linear or branched monovalent hydrocarbon group having a carbon-carbon triple bond.

As used herein, when a definition is not otherwise provided, "aryl" refers to a group formed by removal of a, e.g., at least one, hydrogen from an arene (e.g., a phenyl or naphthyl group).

As used herein, when a definition is not otherwise provided, "hetero" refers to including 1 to 3 heteroatoms, e.g., N, O, S, Si, P, or a combination thereof.

In an embodiment, "aromatic" or "aromatic group" may include a C6 to C30 aromatic group (e.g., consisting of hydrogen and carbon) or an aromatic ring including a heteroatom (e.g., a C3 to C30 heteroaryl group).

The term "alicyclic group" refers to not only a saturated or unsaturated C3 to C30 cyclic group consisting of carbon and hydrogen but also a saturated or unsaturated C3 to C30 heterocyclic group that further includes a hetero atom in addition to carbon and hydrogen.

As used herein, when a definition is not otherwise provided, "alkoxy" means an alkyl group linked via an oxygen (i.e., alkyl-O-), such as a methoxy, ethoxy, or sec-butyloxy group.

As used herein, when a definition is not otherwise provided, "amine group" may be represented by -NRR, wherein each R is independently hydrogen, a C1 to C12 alkyl group, a C7 to C20 alkylaryl group, a C7 to C20 arylalkyl group, or a C6 to C18 aryl group.

As used herein, the expression "not including cadmium (or other harmful heavy metal)" may refer to the case in which a concentration of each of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other heavy metal) may be present or, if present, an amount of cadmium (or other heavy metal) may be less than or equal to a detection limit or as an impurity level of a given analysis tool (e.g., an inductively coupled plasma atomic emission spectroscopy).

In an embodiment, numerical ranges stated herein are inclusive of the endpoint of each range. As used herein, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, $\pm$ 5% of the stated value.

As used herein, a nanoparticle or a nanostructure is a structure having at least one region or characteristic dimension with a nanoscale dimension. In an embodiment, a dimension (or an average dimension) of the nanoparticle is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or about 1 nm. In an embodiment, the structure may have any suitable shape.

A nanoparticle (e.g., a semiconductor nanoparticle) may include a nanowire, a nanorod, a nanotube, a branched nanostructure, a nanotetrapod, a nanotripod, a nanobipod, a nanodot, or a multi-pod type shape such as at least two pods, and is not limited thereto. The nanoparticle can be, e.g., substantially crystalline, substantially monocrystalline, polycrystalline, (for example, at least partially) amorphous, or a combination thereof.

The semiconductor nanoparticle (e.g., a quantum dot) may exhibit a quantum confinement or exciton confinement effect. The quantum dot is a type of light-emitting nanostructure. As used herein, a shape of the "quantum dot' may not particularly limited. In the present specification, the term "nanoparticle" or "quantum dot" is not limited in shapes thereof unless specifically defined. A semiconductor nanoparticle may have a size smaller than a diameter of Bohr excitation in the bulk crystal of the same material. A semiconductor nanoparticle may emit light of a wavelength corresponding to a bandgap energy thereof by controlling the size of the emission center of the nanocrystals.

As used herein, T50 refers to a time for a luminance (or a photocurrent) of a device to decrease to 50% of the initial luminance (or the initial photocurrent) when the device starts to be driven at a predetermined initial luminance.

As used herein, T90 refers to a time for a luminance (or a photocurrent) of a device to decrease to 90% of the initial luminance (or the initial photocurrent) when the device starts to be driven at a predetermined initial luminance.

As used herein, an external quantum efficiency (EQE) refers to a ratio of the number of photons emitted from a light-emitting diode (LED) to the number of electrons passing through the device. EQE may be a criterion of how efficiently the light-emitting diode converts the electrons into emitted photons. In an embodiment, EQE may be determined based on the following equation:

$$EQE = (Injection\ efficiency) \times (Solid\ state\ quantum\ yield) \times (Extraction\ efficiency)$$

wherein

Injection efficiency is the proportion of electrons passing through the device that are injected into the active region;
Solid state quantum yield is the proportion of all electron-hole recombinations in the active region that are radiative and produce photons; and
Extraction efficiency is the proportion of photons generated in the active region that escape from the device.

Herein, a maximum external quantum efficiency refers to a maximum value of the external quantum efficiency.

Herein, a maximum luminance refers to a maximum value of luminance that the device can achieve.

As used herein, a quantum efficiency is a term used interchangeably with a quantum yield. The quantum efficiency (or quantum yield) may be measured either in solution or in the solid state (in a composite). In an embodiment, the quantum efficiency (or quantum yield) is a ratio of photons emitted to photons absorbed by the nanostructure or population thereof. In an embodiment, the quantum efficiency may be measured by any suitable method. For example, for fluorescence quantum yield or efficiency, there may be two methods: an absolute method and a relative method.

In the absolute method, the quantum efficiency is obtained by detecting fluorescence of all samples through an integrating sphere. In the relative method, the quantum efficiency of an unknown sample is calculated by comparing a fluorescence intensity of a standard dye (standard sample) with a fluorescence intensity of the unknown sample. Coumarin 153, Coumarin 545, Rhodamine 101 inner salt, Anthracene and Rhodamine 6G may be used as standard dyes according to photoluminescence (PL) wavelengths thereof, but the present disclosure is not limited thereto.

A bandgap energy of a semiconductor nanocrystal particle may be changed according to sizes, structures, and compositions of nanocrystals. A semiconductor nanocrystal may be used as a light-emitting material in a variety of fields for example, in a display device, an energy device, or a bio light-emitting device, for example. A semiconductor nanoparticle (e.g., a quantum dot) being configured to exhibit luminescent (e.g., electroluminescent or photoluminescent) properties at a practically applicable, e.g., desirable, level may contain harmful heavy metals such as cadmium (Cd), lead, mercury, or a combination thereof. Accordingly, it is desirable to provide a light-emitting device or a display device having a light-emitting layer substantially free of the harmful heavy metal.

The semiconductor nanoparticle according to an embodiment is environmentally friendly and may emit blue light having a desired wavelength with improved luminous efficiency, and may exhibit improved stability in an external environment. An electroluminescent device according to an embodiment includes the semiconductor nanoparticle and is a self-emissive type light-emitting device configured to emit a desired light by applying a voltage, for example, with or without a light (irradiation) source. The light emitting device and the display device of an embodiment is desirable from an environmental point of view.

A semiconductor nanoparticle in an embodiment includes a Group II-VI compound including zinc, selenium, and, optionally, tellurium (or a first particle including the Group II-VI compound). The semiconductor nanoparticle further includes a semiconductor nanocrystal layer including zinc and sulfur (or including a zinc sulfide). The semiconductor nanocrystal layer may be disposed on the first particle. The first particle may further include a Group III-V compound. The Group III-V compound may include indium and phosphorus. The Group III-V compound may further include zinc.

The first particle may include a first semiconductor nanocrystal and a second semiconductor nanocrystal, the first semiconductor nanocrystal may include a Group II-VI compound including zinc, selenium, and tellurium or a Group III-V compound including indium and phosphorus, and the second semiconductor nanocrystal may include a Group II-VI compound including zinc and selenium.

The second semiconductor nanocrystal may be disposed between the first semiconductor nanocrystal and the semiconductor nanocrystal layer.

The semiconductor nanoparticle may emit blue light or green light. The semiconductor nanoparticle may have an absolute quantum yield of greater than or equal to about 90%. The absolute quantum yield may be greater than or equal to about 91% and less than or equal to about 99%, greater than or equal to about 93% and less than or equal to about 98%, greater than or equal to about 95% and less than or equal to about 96%, or a combination thereof.

The semiconductor nanoparticle may not include cadmium. The semiconductor nanoparticle may not include lead, mercury, or a combination thereof.

A cadmium free semiconductor nanoparticle (e.g., a cadmium free quantum dot) may have a core-shell structure, e.g., with multiple shells. Such a structure can contribute to the realization of an electroluminescent device with a higher efficiency and a longer life span. Without wishing to be bound by any theory, for the application of the quantum dot-based electroluminescent device, a thickness of the semiconductor nanocrystal layer or the shell of the semiconductor nanoparticle may change (e.g., increase or decrease), which is thought to be able to reduce the effect of energy transfer between the quantum dots and to reduce the ratio of ligands.

However, the present inventors have found that it may become more difficult to provide the semiconductor nanocrystal layer as the size of the semiconductor nanoparticle increases. The semiconductor nanocrystal layer may be included in or may constitute an outermost shell of the semiconductor nanoparticle. The semiconductor nanocrystal layer may have, for example, a bandgap energy larger than that of the first particle or the semiconductor nanocrystals contained therein, and may contain a material (e.g., a zinc sulfide) having a relatively small lattice constant. The semiconductor nanocrystal layer may exhibit a lattice mismatch for example with an intermediate shell layer (e.g., a Group II-VI compound including zinc and selenium) contained in the first particle, and it is believed that such a lattice mismatch may cause a substantial decrease in the coating rate of the semiconductor nanocrystal layer on the first particle during the production of the semiconductor nanoparticle. Without wishing to be bound by any theory, a decrease in the coating rate of the semiconductor nanocrystal layer (for example, when the layer is to constitute the outermost layer of the nanoparticle) may lead to an increase in an amount of unreacted precursors (e.g., a metal carboxylate) in the reaction system, and this can damage a surface of the first particle (or of the middle shell contained therein), reducing luminescent properties (e.g., a photoluminescent quantum yield, PL QY) of the resulting semiconductor nanoparticle.

The semiconductor nanoparticle of an embodiment may include, for example, a semiconductor nanocrystal layer formed according to the method described herein. Surprisingly, the present inventors have found that the semiconductor nanoparticle including the semiconductor nanocrystal layer formed in the method of an embodiment may contribute to allowing an electronic device such as electroluminescent devices to have improved luminescent properties and increased lifespan when being included in the electronic device.

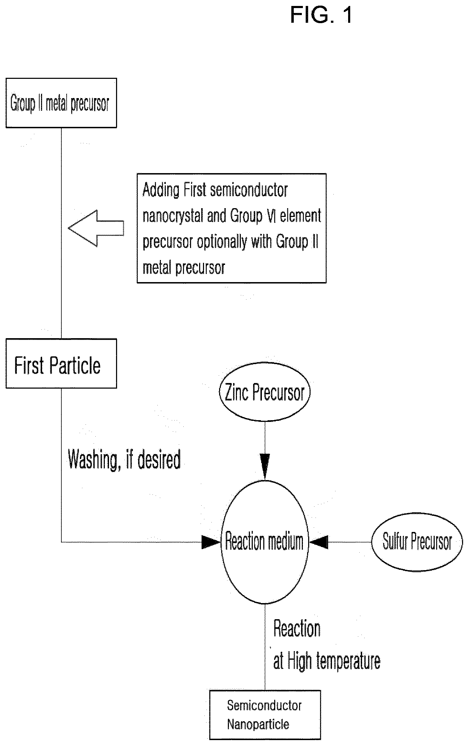

Accordingly, in an embodiment, the method of preparing a semiconductor nanoparticle includes contacting a zinc precursor with a sulfur precursor (for example, the contacting resulting in a reaction of the two precursors) at a predetermined temperature in the presence of a first particle to form a semiconductor nanocrystal layer including a zinc sulfide on the first particle. See. FIG. 1.

The first particle includes a Group II-VI compound including zinc, selenium, and, optionally, tellurium. In the method of an embodiment, the predetermined temperature (or a temperature for the reaction) may include (or may be) a temperature of greater than or equal to about 320 °C and less than or equal to about 380 °C. The sulfur precursor may include a thiol compound, for example a monothiol compound, having a substituted or unsubstituted, C3-C50, C6-C30, C8-24, C9-C40, C10-C36, C12-18, or C14-C16(aliphatic or aromatic) hydrocarbon group. The sulfur precursor or the thiol compound may include a substituted or unsubstituted, C3-C50, C6-C30, C8-24, C9-C40, C10-C36, C12-18, or C14-C16 linear or branched aliphatic hydrocarbon group, a substituted or unsubstituted C6-C30 aromatic hydrocarbon group, or a combination thereof. The aliphatic hydrocarbon group may include a branched C3 to C30 (e.g., C8-C16 or C12-C14) aliphatic hydrocarbon group or a C8-C16 (e.g., C12-C14) aliphatic hydrocarbon group. The carbon number of the thiol compound or the sulfur precursor may be greater than or equal to about 3, greater than or equal to about 8, greater than or equal to about 9, greater than or equal to about 10, greater than or equal to about 11, or greater than or equal to about 12. The carbon number of the thiol compound or the sulfur precursor may be less than or equal to 50, less than or equal to about 40, less than or equal to about 35, or less than or equal to about 20.

The first semiconductor nanocrystal (herein at times, can be referred to as "core") can be prepared appropriately, for example, in any suitable method. In an embodiment, the first semiconductor nanocrystal is commercially available or can be synthesized by any appropriate method.

In an embodiment, the first semiconductor nanocrystal (or the core) includes a Group III-V compound including indium and phosphorus, and may be formed by a hot injection method in which a solution including a metal precursor such as an indium precursor and, optionally, a ligand is heated at a high temperature (e.g., to a temperature of greater than or equal to about 200 °C) and a phosphorus precursor is injected into the reaction flask. In an embodiment, the first semiconductor nanocrystal can be prepared by injecting a phosphorus precursor into a heated reaction medium including an indium precursor in which the heated medium (flask) is at a predetermined temperature to provide a reaction system followed by increasing the temperature of the resulting reaction system to a reaction temperature.

A type of the indium precursor is not particularly limited and can be selected appropriately. The indium precursor may include, but are not limited to, trimethylindium, an indium acetate, an indium hydroxide, indium chloride, an indium oxide, an indium nitrate, and an indium sulfate. Types of the phosphorus precursor are not particularly limited and can be selected appropriately. The phosphorus precursor may include but is not limited to tris(trimethylsilyl) phosphine, tris(dimethylamino) phosphine, triethylphosphine, tributylphosphine, trioctyl phosphine, triphenylphosphine, tricyclohexylphosphine, or a combination thereof.

In an embodiment, the first semiconductor nanocrystal or the core may include a first zinc chalcogenide including zinc, selenium, and tellurium. The first semiconductor nanocrystal or the core may be prepared by a method including: preparing a zinc precursor solution including a zinc precursor and an organic ligand; preparing a selenium precursor and a tellurium precursor; heating the zinc precursor solution to a core formation reaction temperature; and adding the selenium precursor, the tellurium precursor, and optionally an organic ligand to the zinc precursor solution, and conducting a core formation reaction. The types of zinc, selenium, and tellurium precursors are described herein.

In the core formation reaction, a ratio between the precursors (e.g., a mole ratio between zinc and selenium precursors, a mole ratio of the tellurium precursor to the selenium precursor, or the reaction time can be selected appropriately, taking into consideration a desired peak emission wavelength of a resulting semiconductor nanoparticle, the reactivity of the precursor, the reaction temperature, or a combination thereof.

The reaction time for the core formation is not particularly limited and can be selected accordingly. The reaction time for the core formation can be adjusted based on a desired core size, reactivity of the precursor, or the like. The core formation reaction time can be in a range of from about 1 minute to about 120 minutes, from 5 minutes to about 100 minutes, from about 10 minutes to about 80 minutes, from about 15 minutes to about 60 minutes, from about 25 minutes to about 45 minutes, from about 30 minutes to about 35 minutes, or a combination thereof. The temperature of the core-forming reaction is also not particularly limited and can be selected appropriately. For example, in the case of an indium phosphide-based first semiconductor nanocrystal, the core formation reaction temperature may be from about 200 °C to about 300 °C, from about 240 °C to about 290 °C, from about 250 °C to about 280 °C, or a combination thereof. For example, in the case of the first semiconductor nanocrystal including the first zinc chalcogenide, the reaction temperature for core formation is from about 200°C to about 340°C, e.g., from about 220°C to about 330°C. The reaction temperature for core formation can range from about 230 °C to about 320 °C, from about 240 °C to about 310 °C, from about 250 °C to about 300 °C, or any combination of the stated low and high temperatures above.

The formed first semiconductor nanocrystal may be separated or may not be separated from the reaction system (e.g., via a non-solvent precipitation method). Separated cores can optionally be washed and then added to a subsequent reaction.

In an embodiment, the first particle may further include a second semiconductor nanocrystal (e.g., disposed on the first semiconductor nanocrystal), and the second semiconductor nanocrystal may include a second zinc chalcogenide including zinc and selenium. The second zinc chalcogenide may further include or may not include sulfur. The second zinc chalcogenide may include a zinc selenide, a zinc selenide sulfide, or a combination thereof.

In an embodiment, the first particle includes the second semiconductor nanocrystal and may be obtained by a method comprising:

heating (or pre-treating) a reaction medium including a zinc precursor, a solvent, and optionally an organic ligand to a predetermined temperature (e.g., of greater than or equal to about 100 °C and less than or equal to about 180 °C) under vacuum, followed by changing an atmosphere inside a reactor into an inert gas atmosphere (e.g., adding or flowing an inert gas to the reaction system), and heating of the reaction system to a reaction temperature, adding a first semiconductor nanocrystal and a selenium precursor (and optionally a sulfur precursor) to the reaction system (e.g., at an injection temperature), and then carrying out a reaction at the reaction temperature to obtain a first particle including the second semiconductor nanocrystal.

In the method of an embodiment, the selenium precursor optionally together with the zinc precursor may be injected into the reaction system intermittently, i.e. in at least two different aliquots, respectively (for example, to form a second semiconductor nanocrystal or a first particle). In the method of an embodiment, the sulfur precursor, optionally together with the zinc precursor, may be injected into the reaction system at once, or may be divided in two or more doses.

The injection temperature can be selected appropriately. The injection temperature may be greater than or equal to about 100 °C, greater than or equal to about 150 °C, greater than or equal to about 180 °C, or greater than or equal to about 240 °C and less than or equal to about the reaction temperature. A reaction condition such as a reaction temperature and a reaction time for the formation of the second semiconductor nanocrystal can be selected appropriately taking into consideration the composition of the first semiconductor nanocrystal and a desired composition of the resulting semiconductor nanoparticle. The reaction temperature for the formation of the second semiconductor nanocrystal can be greater than or equal to about 240 °C, greater than or equal to about 260 °C, greater than or equal to about 280 °C, or greater than or equal to about 300 °C and less than or equal to about 380 °C, less than or equal to about 350 °C, or less than or equal to about 330 °C.

The obtained first particle may be separated from the reaction system for the formation of the second semiconductor nanocrystal, and the separated first particle may optionally be washed with a washing solvent and then dispersed in a dispersing solvent (e.g., an alkane solvent such as hexane, octane, or the like, or an aromatic hydrocarbon solvent). The first particle optionally together with its dispersing solvent may be provided for a reaction system of forming the semiconductor nanocrystal layer.

The reaction medium may include an organic solvent and optionally an organic ligand. The reaction medium may be pretreated at a predetermined temperature under vacuum. The pretreatment temperature may be greater than or equal to about 80 °C, greater than or equal to about 90 °C, greater than or equal to about 100 °C, greater than or equal to about 120 °C, and less than or equal to about 180 °C, or less than or equal to about 150 °C. In an embodiment, the reaction system may include the zinc precursor prior to the pretreatment.

The method may include adding the first particle, and/or the sulfur precursor, at a first temperature to a reaction medium including an organic solvent. The method may include adding a zinc precursor to the reaction medium (for example, at the first temperature). See, Fig. 1.

The first temperature may be greater than or equal to about 180 °C, greater than or equal to about 190 °C, greater than or equal to about 200 °C, greater than or equal to about 210 °C, greater than or equal to about 220 °C, greater than or equal to about 225 °C, greater than or equal to about 230 °C, greater than or equal to about 235 °C, greater than or equal to about 240 °C, or greater than or equal to about 280 °C. The first temperature may be lower than the predetermined temperature or the reaction temperature for the formation of the semiconductor nanocrystal layer (hereinafter, referred to as the reaction temperature for the ZnS formation). The first temperature may be less than or equal to about 320 °C, less than or equal to about 319 °C, less than or equal to about 310 °C, less than or equal to about 305 °C, less than or equal to about 300 °C, less than or equal to about 290 °C, less than or equal to about 280 °C, less than or equal to about 270 °C, less than or equal to about 260 °C, or less than or equal to about 250 °C.

The reaction temperature for the semiconductor nanocrystal layer (e.g., including a ZnS) formation may be greater than or equal to about 325 °C, greater than or equal to about 330 °C, greater than or equal to about 331 °C, greater than or equal to about 335 °C, greater than or equal to about 336 °C, greater than or equal to about 337 °C, greater than or equal to about 338 °C, greater than or equal to about 339 °C, greater than or equal to about 340 °C, greater than or equal to about 341 °C, greater than or equal to about 342 °C, greater than or equal to about 343 °C, greater than or equal to about 344 °C, or greater than or equal to about 345 °C. The reaction temperature for the ZnS formation may be (may include a temperature of) from about 300 °C to about 390 °C, from about 319 °C to about 380 °C, from about 320 °C to about 375 °C, from about 325 °C to about 370 °C, from about 330 °C to about 360 °C, from about 335 °C to about 360 °C, from about 336 °C to about 360 °C, from about 340 °C to about 355 °C, from about 345 °C to about 355 °C, from about 350 °C to about 355 °C, or any combination of the stated low and high temperatures above.

Through their leading and extensive research with semiconductor nanoparticles, the present inventors have found that a semiconductor nanoparticle including a semiconductor nanocrystal layer that is prepared using a thiol-based sulfur precursor may include a significant amount of a thiol-derived ligand on a surface of the resulting nanoparticle, and this may adversely affect performance of an electroluminescent device that includes the semiconductor nanoparticle.

Surprisingly, upon further research, the present inventors have found that by using a thiol-based sulfur precursor in a manner described herein under a reaction condition described herein, for example, according to the method of an embodiment, an improved quality can be achieved for the semiconductor nanocrystal layer (e.g., the ZnS layer) thus formed, and the resulting semiconductor nanoparticle of an embodiment can contribute to increased lifetime with improved electroluminescence properties in an electroluminescent device as it is included in the device, unlike a semiconductor nanoparticle prepared using already known, e.g., conventional preparatory methods.

Surprisingly, in accordance to a method of preparation of a nanoparticle of an embodiment, the semiconductor nanocrystal layer can be formed at an increased coating rate by using the precursor described herein along with the reaction conditions described herein. In addition, the semiconductor nanoparticle thus prepared may exhibit a controlled ligand composition. Without wishing to be bound by any theory, it is believed that in the method of an embodiment, the reaction condition together with the type of the ligand composition may contribute to reducing the defects at an interface or a surface in the semiconductor nanoparticle.

In the method of an embodiment, the sulfur precursor can exhibit a more stably controlled (e.g., increased) reactivity in the reaction system, and under the reaction conditions described herein the surface ligand of the resulting semiconductor nanoparticle can be controlled in a desired state, and thus a resulting light emitting (e.g., electroluminescent) device including the semiconductor nanoparticle can exhibit increased lifetime together with an improved light emitting efficiency. It is believed that the formation of the semiconductor nanocrystal layer in the manner described herein can also lead to a more control over the oxidation of the semiconductor nanoparticle, and this can provide a more uniformly formed shell, and thereby, reduce surface defects of the nanoparticle.

In an embodiment, the sulfur precursor may include a compound represented by R-SH, where R is a C8-C50 (or C9-C45) substituted or unsubstituted aliphatic or aromatic hydrocarbon group (e.g., alkyls, alkenyls, alkynyls, phenyl, benzyl, etc.). The sulfur precursor may include or may not include octane thiol. In an embodiment, the sulfur precursor may include a ethylhexyl thiol, decane thiol, undecane thiol, dodecane thiol, tetradecane thiol, hexadecane thiol, octadecane thiol, or a mixture thereof.

The sulfur precursor may include or may not include a sulfur-hydrocarbon solvent adduct (e.g., a sulfur-hydrocarbon complex), for example, prepared by dispersing or reacting sulfur in the hydrocarbon solvent. See, below, The sulfur precursor may include or may not include bis(trialkylsilyl)alkyl sulfide (e.g., bis(trimethylsilyl)methyl sulfide), bis(trialkylsilyl) sulfide (e.g., bis(trimethylsilyl) sulfide), or a combination thereof. In the method of an embodiment, an additional sulfur precursor (e.g., the aforementioned sulfur-hydrocarbon solvent adduct or the aforementioned sulfide-based precursor) may be used in addition to the thiol type precursor or the additional sulfur precursor may not be used.

The sulfur-hydrocarbon solvent adduct may be prepared by dispersing a sulfur powder or elemental sulfur in a substituted or unsubstituted hydrocarbon group-containing solvent (e.g., an aliphatic hydrocarbon solvent such as octadecene, a phosphine solvent with an aliphatic or aromatic hydrocarbon group such as trioctyl phosphine, diphenyl phosphine, and triphenyl phosphine, and an amine solvent with an aliphatic hydrocarbon group such as trioctylamine) and stirring it at a predetermined temperature. In an embodiment, the sulfur-hydrocarbon solvent adduct may include S-TOP, S-TOA, S-ODE, S-TBP, S-TPP, or a combination thereof. The method of preparation of the sulfur-hydrocarbon solvent adduct is not particularly limited, and any known method can be adopted.

The amount of each precursor used in the method of an embodiment can be selected appropriately taking into consideration a desired composition of the final semiconductor nanoparticle, the reactivity of the precursor, and the reaction conditions. In the method, each precursor (e.g., a zinc precursor, a sulfur precursor, or both) may be added in a predetermined amount at once or divided and injected in at least two times, for example, at least three times and, for example, up to ten times, or five times.

In an embodiment, the first semiconductor nanocrystal includes a Group III-V compound including indium, phosphorus, and, optionally, zinc, and an amount of the zinc precursor used for the formation of the second semiconductor nanocrystal and the semiconductor nanocrystal layer may be, per one mole of indium greater than or equal to about 60 moles, greater than or equal to about 65 moles, greater than or equal to about 70 moles, greater than or equal to about 75 moles, greater than or equal to about 80 moles, or greater than or equal to about 85 moles. The amount of the zinc precursor may be, per one mole of indium, less than or equal to about 250 moles, less than or equal to about 200 moles, less than or equal to about 150 moles, less than or equal to about 100 moles, less than or equal to about 90 moles, or less than or equal to about 85 moles.

In the method of an embodiment, the amount of the selenium precursor for the formation of the second semiconductor nanocrystal may be, per 1 mole of indium greater than or equal to about 40 moles, greater than or equal to about 50 moles, greater than or equal to about 60 moles, greater than or equal to about 70 moles, greater than or equal to about 80 moles, or greater than or equal to about 90 moles. The amount of the selenium precursor may be, per 1 mole of indium, less than or equal to about 200 moles, less than or equal to about 170 moles, less than or equal to about 150 moles, less than or equal to about 130 moles, less than or equal to about 110 moles, less than or equal to about 90 moles, less than or equal to about 80 moles, less than or equal to about 70 moles, less than or equal to about 60 moles, or less than or equal to about or 55 moles.

In an embodiment, the first semiconductor nanocrystal includes a first zinc chalcogenide including zinc, selenium, and tellurium. In the embodiment, the amount of selenium precursor used for the formation of the second semiconductor nanocrystal may be, per 1 mol of a zinc precursor, greater than or equal to about 0.1 mol, greater than or equal to about 0.3 mol, greater than or equal to about 0.5 moles, greater than or equal to about 0.65 moles, greater than or equal to about 0.7 moles, greater than or equal to about 0.9 moles, greater than or equal to about 1 moles, greater than or equal to about 1.5 moles, or greater than or equal to about 2 moles. The amount of the selenium precursor may be less than 5 moles, less than or equal to about 4 moles, less than or equal to about 3 moles, less than or equal to about 2 moles, or less than or equal to about 1 mole, per 1 mole of the zinc precursor, but is not limited thereto.

In connection with the formation of the semiconductor nanocrystal layer, for example, the amount of the sulfur precursor can be determined by taking into account the type of precursors used, the reaction temperature, and a desired composition of the resulting nanoparticle. The amount of sulfur precursors (the thiol compound, or, the additional sulfur precursor, if any, or the total amount of the thiol compound and additional sulfur precursor) (hereinafter referred to as the amount of the sulfur precursor) may be greater than or equal to about 0.05 moles, greater than or equal to about 0.1 moles, and less than or equal to about 10 moles, or less than or equal to 5 moles, per one mole of zinc in the zinc precursor. The amount of the sulfur precursor may be, per 1 mole of zinc of the zinc precursor, greater than or equal to about 0.08 moles, greater than or equal to about 0.1 moles, greater than or equal to about 0.15 moles, greater than or equal to about 0.2 moles, greater than or equal to about 0.25 moles, greater than or equal to about 0.3 moles, greater than or equal to about 0.5 moles, greater than or equal to about 0.65 moles, greater than or equal to about 0.7 moles, greater than or equal to about 0.85 moles, greater than or equal to about 0.9 moles, greater than or equal to about 1 mole, greater than or equal to about 1.2 moles, greater than or equal to about 1.3 moles, greater than or equal to about 1.5 moles, greater than or equal to about 1.8 moles, greater than or equal to about 2 moles, greater than or equal to about 2.5 moles, greater than or equal to about 3 moles, greater than or equal to about 3.5 moles, greater than or equal to about 4 moles, greater than or equal to about 4.5 moles, greater than or equal to about 5 moles, greater than or equal to about 5.5 moles, greater than or equal to about 6 moles, greater than or equal to about 6.5 moles, greater than or equal to about 7 moles, greater than or equal to about 7.5 moles, greater than or equal to about 8 moles, greater than or equal to about 8.5 moles, or greater than or equal to about 9 mol.

The amount of the sulfur precursor may be less than or equal to about 5 moles, less than or equal to about 3 moles, less than or equal to about 2.2 moles, or less than or equal to about 1.7 moles, per 1 mole of zinc in the zinc precursor.

In the method of an embodiment, the zinc precursor may be a Zn metal powder, ZnO, an alkylated Zn compound (e.g., a C2 to C30 dialkyl zinc such as diethyl zinc), a Zn alkoxide (e.g., a zinc ethoxide), a Zn carboxylate (e.g., a zinc acetate), a Zn nitrate, a Zn perchlorate, a Zn sulfate, Zn acetylacetonate, a Zn halide (e.g., a zinc chloride), a Zn cyanide, a Zn hydroxide, a Zn carbonate, a Zn peroxide, or a combination thereof. Examples of the zinc precursor may include dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof, but is not limited thereto.

In an embodiment, for the formation of the semiconductor nanocrystal layer, the zinc precursor may include a zinc carboxylate having a C1 to C60 (or a C5 to C40) substituted or unsubstituted aliphatic hydrocarbon group. In an embodiment, for the formation of the semiconductor nanocrystal layer, the zinc precursor may include two or more different precursor compounds.

The zinc precursor may include a compound that is represented by chemical formula 1:

Chemical Formula 1     ACOO-Zn-OOCB

In Chemical Formula 1, A and B are the same or different, and each independently a substituted or unsubstituted C1 to C60 (linear or branched) aliphatic hydrocarbon (e.g., alkyl, alkenyl, or alkynyl) group, or a substituted or unsubstituted C3 to C60 (or C6 to C30) aromatic hydrocarbon group.

In Chemical Formula 1, A and B are the same or different, and each independently may include a substituted or unsubstituted, C1-C60, C12-C24, C16-C20, C4-C18, or C6-C8 linear or branched aliphatic hydrocarbon group; a substituted or unsubstituted C3-C60, or C6-C30 aromatic hydrocarbon group (or aryl group) such as a phenyl group, a benzyl group, or a naphthyl group; or a combination thereof.

In Chemical Formula 1, A and B may be the same or different, respectively, and may be a ethylhexyl group, a methylbutyl group, a hexyldecyl group, a oleyl group, a myristyl group, a stearyl group, an aryl group (e.g., a phenyl group or a benzyl group), or a combination thereof.

The zinc precursor may include a zinc carboxylate (i.e., a first zinc precursor) with a linear aliphatic hydrocarbon group of C12-C60, C16-C24, or C18-C22 such as a zinc oleate, a zinc myristate, a zinc stearate, etc; a zinc carboxylate (i.e., a second zinc precursor) with a C3-C40, C4-C20, C4-C18, or C6-C8 branched aliphatic hydrocarbon group such as a zinc ethylhexanoate (e.g., 2-ethylhexaonoate zinc) , a zinc methylbutanoate (e.g., zinc 3-methylbutanoate), a zinc hexyldecanoate (zinc 2-hexyldecanoate), etc.; or a combination thereof (e.g., a mixture thereof).

In an embodiment, a mixture of the zinc precursors may be used, and a mole ratio between the first and second zinc precursors can be selected appropriately. In an embodiment, the mole ratio between the first zinc precursor and the second zinc precursor (first zinc precursor: second zinc precursor) may be from about 1:10 to about 10:1, from about 1:8 to about 8:1, from about 1:6 to about 6:1, from about 1:5 to about 5:1, from about 1:5.25 to about 5.25:1, from about 1:4 to about 4:1, from about 1:3 to about 3:1, from about 1:2 to about 2:1, or a combination thereof.

The selenium precursor may include selenium-trioctylphosphine ("Se-TOP"), selenium-tributylphosphine ("Se-TBP"), selenium-triphenylphosphine ("Se-TPP"), selenium-diphenylphosphine ("Se-DPP"), or a combination thereof, but is not limited thereto.

The tellurium precursor may include tellurium-tributylphosphine ("Te-TBP"), tellurium-triphenylphosphine ("Te-TPP"), tellurium-diphenylphosphine ("Te-DPP"), or a combination thereof, but is not limited thereto.

The sulfur precursors used in the preparation of the first or second semiconductor nanocrystals are not particularly limited and can be selected appropriately. The sulfur precursor may be hexane thiol, octane thiol, decane thiol, dodecane thiol, hexadecane thiol, mercapto propyl silane, sulfur-trioctylphosphine ("S-TOP"), sulfur-tributylphosphine ("S-TBP"), sulfur-triphenylphosphine ("S-TPP"), sulfur-trioctylamine ("S-TOA"), a bis(trialkylsilyl) sulfide, a bis(trialkylsilylalkyl) sulfide e.g., bis(trimethylsilylmethyl) sulfide, ammonium sulfide, sodium sulfide, or a combination thereof. In the formation of semiconductor nanocrystal layer including the zinc sulfide, the aforementioned sulfur precursors used in the preparation of the first semiconductor nanocrystals or the second semiconductor nanocrystals may be used in combination with the thiol-based sulfur precursors described herein.

The organic solvent may include a C6 to C22 primary amine such as hexadecylamine or oleylamine, a C6 to C22 secondary amine such as dioctylamine, a C6 to C40 tertiary amine such as trioctylamine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine substituted with a, e.g., at least one (e.g., 1, 2, or 3) C6 to C22 alkyl group (e.g., trioctylphosphine), a phosphine oxide substituted with a, e.g., at least one (e.g., 1, 2, or 3) C6 to C22 alkyl group (e.g., trioctyl phosphine oxide), a C12 to C22 aromatic ether such as phenyl ether or benzyl ether, or a combination thereof.

The semiconductor nanoparticles may have an organic ligand on a surface thereof. The organic ligand may coordinate, e.g., bind to, the surface of the produced nanocrystal and may have an effect on light emitting and electric characteristics of the nanocrystal and/or may effectively disperse the nanocrystal in an organic solvent. The organic ligand may include $RCOOH$, $RNH_2$, $R_2NH$, $R_3N$, $RSH$, $RH_2PO$, $R_2HPO$, $R_3PO$, $RH_2P$, $R_2HP$, $R_3P$, $ROH$, $RCOOR'$, $RPO(OH)_2$, $R_2POOH$, or a combination thereof, wherein, R and R' independently are a substituted or unsubstituted C1 to C40 (e.g., C3 to C24) aliphatic hydrocarbon group, a substituted or unsubstituted C6 to C40 (e.g., C6 to C24) aromatic hydrocarbon group, or a combination thereof. One or more organic ligands may be used.

Examples of the organic ligand compound may include methane thiol, ethane thiol, propane thiol, butane thiol, pentane thiol, hexane thiol, octane thiol, dodecane thiol, hexadecane thiol, octadecane thiol, benzyl thiol; methane amine, ethane amine, propane amine, butane amine, pentane amine, hexane amine, octane amine, dodecane amine, hexadecyl amine, oleyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid, palmitic acid, or stearic acid; a phosphine such as methyl phosphine, ethyl phosphine, propyl phosphine, butyl phosphine, pentyl phosphine, tributyl phosphine, or trioctyl phosphine; a phosphine oxide compound such as methyl phosphine oxide, ethyl phosphine oxide, propyl phosphine oxide, butyl phosphine oxide, or trioctyl phosphine oxide; a diphenyl phosphine or triphenyl phosphine compound, or an oxide compound thereof; a C5 to C20 alkyl phosphonic acid; a C5 to C20 alkyl phosphinic acid such as hexylphosphinic acid, octylphosphinic acid, dodecanephosphinic acid, tetradecanephosphinic acid, hexadecanephosphinic acid, octadecanephosphinic acid; phosphonic acid; or the like, but are not limited thereto. One or more organic ligand compounds may be used. In an embodiment, the organic ligand compound may be a combination of $RCOOH$ and an amine (e.g., $RNH_2$, $R_2NH$, $R_3N$, or a combination thereof) wherein, R is independently a substituted or unsubstituted C1 to C40 (C3-C24) aliphatic hydrocarbon group or a substituted or unsubstituted C6 to C40 (C6-C20) aromatic hydrocarbon group.

The organic ligand compound may include a carboxylic acid. The organic ligand or the carboxylic acid may include a combination of a linear carboxylic acid (e.g., R1COOH, where R1 may include a C5 to C40, C8-C20 linear aliphatic hydrocarbon group) and a branched carboxylic acid (e.g., R2COOH, R2 is a C3 to C40 or C5 to C12 branched aliphatic hydrocarbon group). The number of carbon atoms of R1 may be greater than the number of carbon atoms of R2. The number of carbon atoms of R1 may be less than the number of carbon atoms of R2.

In the case of the formation of the first semiconductor nanocrystal, the second semiconductor nanocrystal, or the semiconductor nanocrystal layer, after the completion of the reaction, a nonsolvent may be added to a reaction product and the nanocrystal or the nanoparticle coordinated with, e.g., bound to, the ligand compound, may be separated. The nonsolvent may be a polar solvent that is miscible with the solvent used in the core formation reaction, shell formation reaction, or a combination thereof and is not capable of dispersing the produced nanocrystals therein. The nonsolvent may be selected taking into consideration the solvent used in the reaction and may be, for example, acetone, ethanol, butanol, isopropanol, ethanediol, water, tetrahydrofuran ("THF"), dimethyl sulfoxide ("DMSO"), diethyl ether, formaldehyde, acetaldehyde, a solvent having a similar solubility parameter to the foregoing non-solvents, or a combination thereof. The nanocrystal particles may be separated through centrifugation, sedimentation, chromatography, or distillation. The separated nanocrystals may be added to a washing solvent and washed, if desired. The washing solvent has no particular limit and may have a similar solubility parameter to that of the ligand and may include, for example, hexane, heptane, octane, chloroform, toluene, benzene, and the like.

The semiconductor nanoparticles of an embodiment may not be dispersible in water, any of the foregoing listed non-solvents, or a mixture thereof. The semiconductor nanoparticles of an embodiment may be water-insoluble.

The semiconductor nanoparticles of an embodiment may be dispersed in the aforementioned organic solvent. In an embodiment, the semiconductor nanoparticles may be dispersed in a C6 to C40 aliphatic hydrocarbon, a C6 to C40 aromatic hydrocarbon, or a mixture thereof.

In an embodiment, the semiconductor nanoparticle may include a first organic ligand including a carboxylate moiety of C12 or higher (for example, derived from the zinc carboxylate such as a zinc oleate or in the form of RCOO) and a second organic ligand including a thiolate moiety (for example, derived from the thiol compound or in the form of R'-S), and as measured by a GC-MS (Gas Chromatography-Mass Spectrometry) analysis, a peak area of the second organic ligand may be less than or equal to about 17%, for example, less than or equal to about 16%, less than or equal to about 15%, less than or equal to about 14%, less than or equal to about 13%, less than or equal to about 12%, less than or equal to about 11%, less than or equal to about 10%, less than or equal to about 9%, less than or equal to about 8%, less than or equal to about 7.5%, less than or equal to about 7%, less than or equal to about 6.5%, less than or equal to about 6%, less than or equal to about 5.5%, less than or equal to about 5%, less than or equal to about 4.5%, less than or equal to about 4%, less than or equal to about 3.8%, less than or equal to about 3.5%, less than or equal to about 2.5%, less than or equal to about 2%, or less than or equal to about 1.5% of a total area of the peaks of the first organic ligand and the second organic ligand. In the above RCOO or RS, R, R' are the same or different and each independently a hydrocarbon group, which may correspond to the hydrocarbon groups defined herein with respect to the zinc precursor and the thiol compound.

In analyzing organic ligands included in the semiconductor nanoparticle, a gas chromatography (GC) may readily and reproducibly provide reliable results. The gas chromatography (GC) is an analytical technique that can be used to separate, identify, and quantify individual chemical components in a mixture. In the GC, a gas may carry a given sample through a GC equipment. In an embodiment, the carrier gas or the mobile phase is not particularly limited and may include (e.g., high purity) helium, hydrogen or nitrogen. In an embodiment, the gas chromatography analysis device may include an injection port (e.g., a split/non-division (SSL) injection port), a column (e.g., a wall-coated open-tube (WCOT) capillary column containing a thin layer of dimethyl polysiloxane fixed phase), and a detector (e.g., flame ionization detector, FID or mass spectrometry, MS), but is not limited thereto. Many gas chromatography analysis devices are commercially available, and measurements can be made according to a user guide provided by each manufacturer in consideration of the compound to be detected. Measurement methods related to GC are known to determine a ligand composition on the semiconductor nanoparticle and can provide substantially the same result.

The area of the peak assigned to the second organic ligand (i.e., the peak area of the second organic ligand) may be greater than or equal to about 0.01%, greater than or equal to about 0.05%, greater than or equal to about 0.1%, greater than or equal to about 0.3%, greater than or equal to about 0.5%, greater than or equal to about 0.7%, or greater than or equal to about 1% of a total area of the peaks of the first and second organic ligands.

Without wishing to be bound by any theory, according to the method of an embodiment, the semiconductor nanoparticle may include an additional ligand (e.g., a fatty acid such as an oleic acid or a C5-C20 or C8 carboxylic acid-derived ligand) along with a limited amount of a thiol-derived ligand.

In an embodiment, as measured in a thermogravimetric analysis, the semiconductor nanoparticle may have a residue weight that is greater than or equal to about 85 wt%, greater than or equal to about 85.5 wt%, greater than or equal to about 87 wt%, or greater than or equal to about 88 wt% and 99 wt% or less. In an embodiment, as measured in a thermogravimetric analysis, the semiconductor nanoparticle may have an amount of organic matters that is less than or equal to about 15 wt%, less than or equal to about 14.5 wt%, less than or equal to about 13.5 wt%, less than or equal to about 13 wt%, less than or equal to about 12.5 wt%, less than or equal to about 12 wt%, less than or equal to about 12 wt%, or less than or equal to about 11.5 wt% and greater than or equal to about 1 wt% or greater than or equal to about 5 wt%.

As measured by a thermogravimetric analysis, the semiconductor nanoparticle may exhibit a first peak (or a first peak temperature) at a temperature of greater than or equal to about 200 °C and less than or equal to about 300 °C, e.g., greater than or equal to about 210 °C and less than or equal to about 280 °C in a differential thermogravimetric curve plotting the derivative weight Vs temp. The semiconductor nanoparticle may exhibit a second peak (or a second peak temperature) that is greater than or equal to about 400 °C and less than or equal to about 500 °C, e.g., greater than or equal to about 410 °C and less than or equal to about 490 °C in the differential thermogravimetric curve. The intensity of the second peak may be greater than or equal to about three times that of the first peak, or it may be greater than or equal to about five times the intensity of the first peak.

In an embodiment, the semiconductor nanoparticle may have a core-shell structure having a core and a shell disposed on the core. The core may include the first semiconductor nanocrystal. The shell may include the semiconductor nanocrystal layer including the zinc sulfide. The shell may further include the second semiconductor nanocrystal or a layer including the second semiconductor nanocrystal (e.g., a first shell layer). The second semiconductor nanocrystal or a layer including the second semiconductor nanocrystal (i.e., the first shell layer) may be placed between the core (or the first semiconductor nanocrystal) and the semiconductor nanocrystal layer (e.g., a second shell layer). The semiconductor nanocrystal layer can constitute or be an outermost layer of the semiconductor nanoparticle of an embodiment.

The shell may have a multi-layered shell structure in which adjacent layers (e.g., the first shell layer and the second shell layer) have different compositions. The shell (or each layer of a multilayered shell) may be a gradient alloy with a composition that varies in a radial direction of the semiconductor nanoparticle. In an embodiment, in the shell, or in the second semiconductor nanocrystal, the sulfur amount may change toward the surface of the semiconductor nanoparticles. For example, in the second semiconductor nanocrystal, the sulfur amount may have a concentration gradient that increases as it moves away from the core or the first semiconductor nanocrystal.

The size of the first semiconductor nanocrystal or the core can be adjusted in consideration of the composition and the peak wavelength of luminescence.

In an embodiment, a size or an average size (hereinafter, at times referred to as "size") of the core or the first semiconductor nanocrystal may be greater than or equal to about 1 nm, greater than or equal to about 1.5 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 3 nm, or greater than or equal to about 5 nm. The size of the core or the first semiconductor nanocrystal may be less than or equal to about 8 nm, less than or equal to about 6 nm, less than or equal to about 5 nm, less than or equal to about 4 nm, less than or equal to about 3.5 nm, less than or equal to about 3 nm, less than or equal to about 2.7 nm, or less than or equal to about 2.5 nm.

In an embodiment, a thickness or an average thickness (hereinafter, "thickness") of the second semiconductor nanocrystal (e.g., a zinc selenide, a zinc selenide sulfide) or the layer including the same (i.e., a thickness of the first shell layer) may be greater than or equal to about 0.7 nm, greater than or equal to about 1 nm, greater than or equal to about 1.2 nm, greater than or equal to about 1.5 nm, greater than or equal to about 1.7 nm, greater than or equal to about 2.1 nm, greater than or equal to about 2.2 nm, greater than or equal to about 2.3 nm, greater than or equal to about 2.4 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.2 nm, greater than or equal to about 3.4 nm, greater than or equal to about 3.6 nm, greater than or equal to about 3.8 nm, or greater than or equal to about 4 nm. The thickness of the first shell layer may be less than or equal to about 6 nm, less than or equal to about 5.5 nm, less than or equal to about 5 nm, less than or equal to about 4.8 nm, less than or equal to about 4.5 nm, less than or equal to about 4 nm, less than or equal to about 3.5 nm, less than or equal to about 3 nm, less than or equal to about 2.5 nm, less than or equal to about 2.3 nm, less than or equal to about 2 nm, less than or equal to about 1.8 nm, less than or equal to about 1.5 nm, or less than or equal to about 1 nm.

In an embodiment, a thickness of the semiconductor nanocrystal layer may be greater than or equal to about 0.1 nm, greater than or equal to about 0.2 nm, greater than or equal to about 0.25 nm, greater than or equal to about 0.3 nm, greater than or equal to about 0.45 nm, greater than or equal to about 0.5 nm, greater than or equal to about 0.7 nm, greater than or equal to about 0.9 nm, greater than or equal to about 1 nm, greater than or equal to about 1.1 nm, greater than or equal to about 1.3 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, or greater than or equal to about 3 nm. The thickness of the semiconductor nanocrystal layer may be less than or equal to about 4 nm, less than or equal to about 3 nm, less than or equal to about 2 nm, less than or equal to about 1.5 nm, less than or equal to about 1 nm, less than or equal to about 0.7 nm, less than or equal to about 0.5 nm, less than or equal to about 0.45 nm, or less than or equal to about 0.32 nm.

A size or an average size (herein simply referred to "size") of the semiconductor nanoparticle may be greater than or equal to about 7.3 nm, greater than or equal to about 7.4 nm, greater than or equal to about 7.5 nm, greater than or equal to about 7.6 nm, greater than or equal to about 7.7 nm, greater than or equal to about 7.8 nm, greater than or equal to about 7.9 nm, greater than or equal to about 8 nm, greater than or equal to about 8.5 nm, greater than or equal to about 9 nm, greater than or equal to about 9.5 nm, greater than or equal to about 10 nm, greater than or equal to about 10.5 nm, greater than or equal to about 11 nm, greater than or equal to about 11.5 nm, greater than or equal to about 12 nm, greater than or equal to about 12.5 nm, greater than or equal to about 13 nm, greater than or equal to about 13.5 nm, greater than or equal to about 14 nm, greater than or equal to about 14.5 nm, greater than or equal to about 15 nm, greater than or equal to about 15.5 nm, or greater than or equal to about 16 nm. The size of the semiconductor nanoparticle may be less than or equal to about 50 nm, less than or equal to about 45 nm, less than or equal to about 40 nm, less than or equal to about 35 nm, less than or equal to about 30 nm, less than or equal to about 25 nm, less than or equal to about 20 nm, less than or equal to about 15 nm, less than or equal to about 14 nm, less than or equal to about 13.5 nm, less than or equal to about 13 nm, less than or equal to about 11 nm, or less than or equal to about 10.2 nm.

The size of the semiconductor nanoparticle may be a diameter or an equivalent diameter calculated under an assumption of a sphere. The particle size of the semiconductor nanoparticle can be determined from an electron microscope image (for example, a transmission electron microscopy image). As used herein, the average may be a mean average. As used herein, the average may be median.

In the semiconductor nanoparticle of an embodiment, a standard deviation of the particle size may be in a range of from about 1% to about 20%, about 2% to about 19%, about 3% to about 18%, from about 4% to about 17%, from about 5% to about 16%, from about 6% to about 14%, from about 7% to about 13%, from about 8% to about 12%, from about 9% to about 11%, or a combination thereof. The semiconductor nanoparticles of an embodiment may have a standard deviation of 10% or less, 9% or less, 8% or less, 7% or less, 6% or less, or 5% or less of the average size.

In an embodiment, the particle size may be readily and reproducibility analyzed and obtained by using an image (a two-dimensional image) obtained from an electron microscopic analysis (e.g., a transmission electron microscopy analysis or a scanning electron microscopy analysis) and using any appropriate (known or commercially available) image analysis program such as "Image J" or an in house or commercially available software (for example, a software made by using a programming language such as phython) for example, according to a manual provided with a manufacturer. The image analysis tool and measurement conditions are not particularly limited.

The semiconductor nanoparticle according to an embodiment may have a relatively reduced level of circularity. Circularity is a shape factor for the degree to which the cross-section of a given particle is close to a circle in consideration of the smoothness of the perimeter.

The circularity may be determined by the following definition in a two-dimensional image obtained by an electron microscopy analysis:

$$\text{circularity} = 4\pi \times \frac{Area}{[Perimeter]^2}$$

wherein "Area" is an area of a two-dimensional image(s) of individual semiconductor nanoparticle(s), and "Perimeter" is a circumference of a two-dimensional image(s) of individual semiconductor nanoparticle(s).

In an embodiment, the semiconductor nanoparticle may have a circularity or an average circularity (referred to as "circularity" herein) of greater than or equal to about 0.77, greater than or equal to about 0.8, greater than or equal to about 0.82, greater than or equal to about 0.83, or greater than or equal to about 0.85 and less than or equal to about 1, less than or equal to about 0.9, less than or equal to about 0.87, less than or equal to about 0.86, less than or equal to about 0.85, or less than or equal to about 0.84.

In an embodiment, the semiconductor nanoparticle may have roundness or an average roundness (hereinafter, "roundness") that is greater than or equal to about 0.65, greater than or equal to about 0.7, greater than or equal to about 0.71, greater than or equal to about 0.72, greater than or equal to about 0.74, greater than or equal to about 0.75 and less than or equal to about 1, less than or equal to about 0.9, less than or equal to about 0.85, less than or equal to about 0.8, less than or equal to about 0.79, or less than or equal to about 0.78.

The roundness is defined by the following equation:

$$\frac{4 \times \text{area}}{\pi \times (\text{major axis})^2}$$

Area: the area of a two-dimensional image of an individual semiconductor nanoparticle.

Major Axis: Longest diameter of the semiconductor nanoparticle.

The semiconductor nanoparticle, according to one embodiment, may exhibit an increased level of solidity. The solidity, S is defined by the following equation, as the image area A, divided by the convex hull area, Ac.

$$S = \frac{A}{A_C}$$

A: an area of a two-dimensional image of an individual semiconductor nanoparticle
Ac: an area of a convex hull of the two-dimensional image of an individual semiconductor nanoparticle

The semiconductor nanoparticles may exhibit a relatively high solidity. In an embodiment, the semiconductor nanoparticle or a population thereof may have a solidity or an average solidity (referred to as "solidity" herein) of greater than or equal to about 0.97, greater than or equal to about 0.975, or greater than or equal to about 0.98. The solidity may be less than or equal to about 1, or less than or equal to about 0.99.

The shape factors (e.g., the circularity, or the solidity) may be obtained readily and reproducibility from a two-dimensional electron microcopy image of the particles using a universal image analysis program (e.g., Image J developed by NIH) and a manual of the program producer (e.g., Image J User Guide IJ 1.46r) or an in-house image program made by a coding language (e.g., a commercially available coding language such as Matlab).

In an embodiment, the semiconductor nanoparticle, a light emitting layer including the semiconductor nanoparticle, or a light emitting device (e.g., the electroluminescent device) including the semiconductor nanoparticle may be configured to emit blue light, green light, or red light. In an embodiment, the semiconductor nanoparticle, the light emitting layer including the semiconductor nanoparticle, or the light emitting device may emit blue light, for example, by light excitation, i.e., when the light emitting layer is irradiated with light, or by an application of a voltage. In an embodiment, the semiconductor nanoparticle, the light emitting layer, or the light emitting device may emit green light, for example, by light excitation, e.g., when irradiated with light, or by an applied voltage. In an embodiment, the semiconductor nanoparticle, the light emitting layer, or the light emitting device may emit red light, for example, by light excitation, e.g., when irradiated with light, or by an applied voltage.

A peak emission wavelength of the blue light may be greater than or equal to about 430 nm, greater than or equal to about 435 nm, greater than or equal to about 440 nm, greater than or equal to about 446 nm, greater than or equal to about 449 nm, greater than or equal to about 450 nm, greater than or equal to about 455 nm, greater than or equal to about 460 nm, greater than or equal to about 465 nm, greater than or equal to about 470 nm, greater than or equal to about 477 nm and less than about 480 nm (for example, less than or equal to about 470 nm, less than or equal to about 465 nm, less than or equal to about 460 nm, or less than or equal to about 455 nm. A peak emission wavelength of the blue light may be greater than or equal to about 453 nm, greater than or equal to about 455 nm, greater than or equal to about 458 nm, greater than or equal to about 460 nm, greater than or equal to about 465 nm, greater than or equal to about 466 nm, greater than or equal to about 468 nm, or greater than or equal to about 470 nm. A peak emission wavelength of the blue light may be less than or equal to about 475 nm, less than or equal to about 473 nm, less than or equal to about 472 nm, or less than or equal to about 470 nm.

A peak emission wavelength of the green light may be greater than or equal to about 480 nm, for example, greater than or equal to about 490 nm, greater than or equal to about 500 nm, greater than or equal to about 510 nm, greater than or equal to about 515 nm, greater than or equal to about 520 nm, greater than or equal to about 525 nm, greater than or equal to about 530 nm, greater than or equal to about 535 nm, or greater than or equal to about 540 nm, and/or less than or equal to about 580 nm, less than or equal to about 570 nm, less than or equal to about 565 nm, less than or equal to about 560 nm, less than or equal to about 555 nm, less than or equal to about 550 nm, or less than or equal to about 545 nm.

A peak emission wavelength of the red light may be greater than or equal to about 600 nm and less than or equal to about 650 nm.

The semiconductor nanoparticle of an embodiment may exhibit increased light emitting efficiency. The semiconductor nanoparticle may exhibit a quantum yield (for example, an absolute quantum yield, herein, referred to as "quantum yield") that is greater than or equal to about 90%, greater than or equal to about 91%, greater than or equal to about 92%, greater than or equal to about 93%, greater than or equal to about 94%, greater than or equal to about 95%, greater than or equal to about 96%, greater than or equal to about 97%, greater than or equal to about 98%, or greater than or equal to about 99%. The quantum yield may be from about 75% to about 100%, from about 80% to about 99%, 85% to about 98%, from about 90% to about 95%, or a combination thereof. In an embodiment, the semiconductor nanoparticle may have a quantum yield of greater than or equal to about 65%. In an embodiment, the quantum yield of the semiconductor nanoparticle may be greater than or equal to about 65%, greater than or equal to about 70%, greater than or equal to about 75%, greater than or equal to about 80%, greater than or equal to about 85%, or greater than or equal to about 88%.

The semiconductor nanoparticle or the light-emitting layer including the semiconductor nanoparticle may exhibit (e.g., a luminescent peak of) a full width at half maximum that is less than or equal to about 50 nm. The full width at half maximum may be less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, less than or equal to about 35 nm, less than or equal to about 34 nm, or less than or equal to about 33 nm. The full width at half maximum may be greater than or equal to about 2 nm, greater than or equal to about 5 nm, greater than or equal to about 10 nm, greater than or equal to about 12 nm, or greater than or equal to about 15 nm.

Here, the optical properties of semiconductor nanoparticles (e.g., a photoluminescent quantum yield, PLQY, a UV absorption property, a full width at half maximum, FWHM, etc.) are measured at room temperature, e.g. a temperature of 20 °C to 25 °C, unless otherwise noted.

In an embodiment, a semiconductor nanoparticle includes zinc, selenium, tellurium, and sulfur, and does not include cadmium, the semiconductor nanoparticle is configured to emit a blue light, the semiconductor nanoparticle has an absolute quantum yield of greater than or equal to about 90%, or greater than or equal to about or equal to 95%, the mole ratio of zinc to selenium may be greater than or equal to about 1:1, or greater than or equal to about or equal to about 1.5:1 and less than or equal to about 3:1, less than or equal to about 2.5:1, or less than or equal to about 2.3:1. In the semiconductor nanoparticle, a mole ratio of sulfur to tellurium (S:Te) may be greater than or equal to about 10:1, or greater than or equal to about 50:1 and less than or equal to about 180:1, or less than or equal to about 120:1. The semiconductor nanoparticle may include the semiconductor nanocrystal layer. The semiconductor nanoparticle may exhibit the structure and/or the properties described herein. The blue light may have a peak wavelength of greater than or equal to about 440 nm, or greater than or equal to about 450 nm and less than about 480 nm, or less than or equal to about 479 nm.

The semiconductor nanoparticle of an embodiment may include the first semiconductor nanocrystal. The first semiconductor nanocrystal may include $ZnTe_xSe_{1-x}$ (wherein x is greater than 0, greater than or equal to about 0.001, greater than or equal to about 0.003, greater than or equal to about 0.005, greater than or equal to about 0.007, greater than or equal to about 0.009, greater than or equal to about 0.01, greater than or equal to about 0.03, greater than or equal to about 0.05, greater than or equal to about 0.09 and less than 0.1, or less than or equal to about 0.04). The core may include or may not include sulfur.

In the semiconductor nanoparticle or the light-emitting layer including the semiconductor nanoparticles, the mole ratio of zinc to selenium (Zn:Se) may be greater than or equal to about 1.1:1, greater than or equal to about 1.2:1, greater than or equal to about 1.3:1, greater than or equal to about 1.4:1, greater than or equal to about 1.5:1, greater than or equal to about 1.6:1, greater than or equal to about 1.7:1, greater than or equal to about 1.8:1, or greater than or equal to about 1.9:1. The mole ratio of zinc to selenium (Zn/Se) may be less than or equal to about 2.8:1, less than or equal to about 2.4:1, less than or equal to about 2.3:1, less than or equal to about 2.25:1, less than or equal to about 2.2:1, less than or equal to about 2.1:1, less than or equal to about 2:1, less than or equal to about 1.95:1, less than or equal to about 1.93:1, less than or equal to about 1.91:1, less than or equal to about 1.9:1, less than or equal to about 1.89:1, less than or equal to about 1.87:1, less than or equal to about 1.85:1, less than or equal to about 1.84:1, less than or equal to about 1.81:1, less than or equal to about 1.8:1, less than or equal to about 1.79:1, less than or equal to about 1.77:1, or less than or equal to about 1.

75:1.

In the semiconductor nanoparticle or the light-emitting layer including the semiconductor nanoparticles, a mole ratio of sulfur to tellurium (S:Te) may be greater than or equal to about 15:1, greater than or equal to about 20:1, greater than or equal to about 25:1, greater than or equal to about 30:1, greater than or equal to about 35:1, greater than or equal to about 40:1, greater than or equal to about 45:1, greater than or equal to about 50:1, greater than or equal to about 55:1, greater than or equal to about 60:1, greater than or equal to about 65:1, greater than or equal to about 70:1, greater than or equal to about 71:1, greater than or equal to about 73:1, greater than or equal to about 74:1, greater than or equal to about 75:1, greater than or equal to about 77:1, greater than or equal to about 79:1, greater than or equal to about 80:1, greater than or equal to about 82:1, greater than or equal to about 84:1, greater than or equal to about 86:1, greater than or equal to about 88:1, greater than or equal to about 89:1, greater than or equal to about 90:1, greater than or equal to about 93:1, greater than or equal to about 95:1, greater than or equal to about 97:1, greater than or equal to about 99:1, or greater than or equal to about 100:1. In the semiconductor nanoparticle or the light-emitting layer including the semiconductor nanoparticles, the mole ratio of sulfur to the tellurium (S:Te) may be less than or equal to about 180:1, less than or equal to about 175:1, less than or equal to about 170:1, less than or equal to about 165:1, less than or equal to about 160:1, less than or equal to about 155:1, less than or equal to about 150:1, less than or equal to about 145:1, less than or equal to about 140:1, less than or equal to about 135:1, less than or equal to about 130:1, less than or equal to about 125:1, less than or equal to about 120:1, less than or equal to about 115:1, less than or equal to about 110:1, less than or equal to about 109:1, less than or equal to about 108:1, less than or equal to about 107:1, less than or equal to about 106:1, less than or equal to about 105:1, less than or equal to about 104:1, less than or equal to about 103:1, less than or equal to about 102:1, less than or equal to about 101:1, less than or equal to about 100:1, less than or equal to about 99:1, less than or equal to about 98:1, less than or equal to about 97:1, less than or equal to about 96:1, less than or equal to about 95:1, less than or equal to about 93:1, less than or equal to about 92:1, or less than or equal to about 91:1.

In the semiconductor nanoparticle or the light-emitting layer including the semiconductor nanoparticles, a mole ratio of tellurium to selenium (Te:Se) may be less than or equal to about 0.1:1, less than or equal to about 0.08:1, less than or equal to about 0.07:1, less than or equal to about 0.06:1, less than or equal to about 0.05:1, less than or equal to about 0.045:1, less than or equal to about 0.04:1, less than or equal to about 0.035:1, less than or equal to about 0.03:1, less than or equal to about 0.025:1, less than or equal to about 0.02:1, less than or equal to about 0.015:1, less than or equal to about 0.01:1, less than or equal to about 0.009:1, less than or equal to about 0.008:1, less than or equal to about 0.007:1, less than or equal to about 0.006:1, or less than or equal to about 0.005:1. The mole ratio of tellurium to selenium (Te:Se) may be greater than or equal to about 0.0001:1, greater than or equal to about 0.00015:1, greater than or equal to about 0.0002:1, greater than or equal to about 0.00025:1, greater than or equal to about 0.0003:1, greater than or equal to about 0.00035:1, greater than or equal to about 0.0004:1, greater than or equal to about 0.00045:1, greater than or equal to about 0.0005:1, greater than or equal to about 0.00055:1, greater than or equal to about 0.0006:1, greater than or equal to about 0.00065:1, greater than or equal to about 0.0007:1, greater than or equal to about 0.00075:1, greater than or equal to about 0.0008:1, greater than or equal to about 0.00085:1, greater than or equal to about 0.0009:1, greater than or equal to about 0.00095:1, greater than or equal to about 0.001:1, greater than or equal to about 0.0015:1, greater than or equal to about 0.002:1, greater than or equal to about 0.0025:1, greater than or equal to about 0.003:1, greater than or equal to about 0.0035:1, greater than or equal to about 0.004:1, or greater than or equal to about 0.0045:1. In the semiconductor nanoparticle of an embodiment, the mole ratio of tellurium to selenium (Te:Se) may be from about 0.004:1 to about 0.01:1. The mole ratio of tellurium to selenium (Te:Se) may be from about 0.0002:1 to about 0.02:1. The mole ratio of tellurium to selenium (Te:Se) may be from about 0.0003:1 to about 0.03:1.

In the semiconductor nanoparticle or the light-emitting layer including the semiconductor nanoparticles, a mole ratio of tellurium to zinc (Te:Zn) may be less than or equal to about 0.02:1, less than or equal to about 0.015:1, less than or equal to about 0.01:1, less than or equal to about 0.009:1, less than or equal to about 0.008:1, less than or equal to about 0.007:1, less than or equal to about 0.006:1, or less than or equal to about 0.005:1. The mole ratio of tellurium to zinc (Te:Zn) may be greater than or equal to about 0.0001:1, greater than or equal to about 0.0005:1, greater than or equal to about 0.001:1, greater than or equal to about 0.0015:1, greater than or equal to about 0.002:1, greater than or equal to about 0.0025:1, greater than or equal to about 0.003:1, greater than or equal to about 0.0035:1, or greater than or equal to about 0.004:1.

In the semiconductor nanoparticle or the light-emitting layer including the semiconductor nanoparticles, a mole ratio of Se to Zn (Se:Zn) may be less than or equal to about 1:1, for example, less than or equal to about 0.95:1, less than or equal to about 0.90:1, less than or equal to about 0.85:1, less than or equal to about 0.8:1, less than or equal to about 0.7:1, less than or equal to about 0.6:1, less than or equal to about 0.55:1, less than or equal to about 0.5:1, less than or equal to about 0.45:1, or less than or equal to about 0.4:1. The mole ratio of Se to Zn (Se:Zn) may be greater than or equal to about 0.1:1, greater than or equal to about 0.2:1, greater than or equal to about 0.3:1, greater than or equal to about 0.4:1, greater than or equal to about 0.45:1, greater than or equal to about 0.46:1, greater than or equal to about 0.48:1, greater than or equal to about 0.5:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, or greater than or equal to about 0.6:1.

In the semiconductor nanoparticle or the light-emitting layer including the semiconductor nanoparticles, a mole ratio of Se + S to zinc [(S+Se):Zn] may be greater than or equal to about 0.5:1, greater than or equal to about 0.6:1, greater than or equal to about 0.7:1, greater than or equal to about 0.8:1, greater than or equal to about 0.85:1, greater than or equal to about 0.88:1, greater than or equal to about 0.89:1, greater than or equal to about 0.9:1, greater than or equal to about 0.91:1, greater than or equal to about 0.92:1, greater than or equal to about 0.93:1, greater than or equal to about 0.94:1, greater than or equal to about 0.95:1, greater than or equal to about 0.96:1, greater than or equal to about 0.97:1, greater than or equal to about 0.98:1, greater than or equal to about 0.99:1, or greater than or equal to about 1:1. In the semiconductor nanoparticle or the light-emitting layer including the semiconductor nanoparticles, a mole ratio of Se + S to zinc [(S+Se):Zn] may be less than or equal to about 3:1, less than or equal to about 2.5:1, less than or equal to about 2:1, less than or equal to about 1.5:1, or less than or equal to about 1.2:1.

In the semiconductor nanoparticle or the light-emitting layer including the semiconductor nanoparticles, a mole ratio of sulfur to selenium (S:Se) may be less than or equal to about 1.5:1, less than or equal to about 1:1, less than or equal to about 0.9:1, less than or equal to about 0.8:1, less than or equal to about 0.79:1, less than or equal to about 0.78:1, less than or equal to about 0.73:1, less than or equal to about 0.7:1, less than or equal to about 0.696:1, less than or equal to about 0.69:1, less than or equal to about 0.67:1, less than or equal to about 0.63:1, less than or equal to about 0.62:1, or less than or equal to about 0.61:1. In an embodiment, In the semiconductor nanoparticle or the light-emitting layer including the semiconductor nanoparticles, a mole ratio of sulfur to selenium (S:Se) may be greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.61:1, greater than or equal to about 0.64:1, greater than or equal to about 0.65:1, greater than or equal to about 0.67:1, greater than or equal to about 0.68:1, greater than or equal to about 0.69:1, greater than or equal to about 0.7:1, greater than or equal to about 0.74:1, or greater than or equal to about 0.76:1.

In the semiconductor nanoparticle or the light-emitting layer including the semiconductor nanoparticles, a mole ratio of sulfur to the sum of selenium and sulfur [S:(S+Se)] may be greater than or equal to about 0.29:1, greater than or equal to about 0.31:1, greater than or equal to about 0.32:1, greater than or equal to about 0.33:1, greater than or equal to about 0.34:1, greater than or equal to about 0.35:1, greater than or equal to about 0.36:1, greater than or equal to about 0.37:1, greater than or equal to about 0.38:1, greater than or equal to about 0.39:1, greater than or equal to about 0.40:1, greater than or equal to about 0.41:1, greater than or equal to about 0.42:1, or greater than or equal to about 0.43:1. The mole ratio of sulfur to the sum of selenium and sulfur [S:(S+Se)] may be less than or equal to about 0.53:1, less than or equal to about 0.52:1, less than or equal to about 0.51:1, less than or equal to about 0.5:1, less than or equal to about 0.49:1, less than or equal to about 0.48:1, less than or equal to about 0.47:1, less than or equal to about 0.46:1, less than or equal to about 0.45:1, less than or equal to about 0.44:1, or less than or equal to about 0.43:1.

A mole amount of an element or a mole ratio among elements (for example, included in the semiconductor nanoparticle or the light emitting layer) as described herein may be determined through, e.g., with, an appropriate analysis tool (e.g., an inductively coupled plasma atomic emission spectroscopy (ICP-AES), an X-ray photoelectron spectroscopy (XPS), an ion chromatography, a transmission electron microscopy energy-dispersive X-ray spectroscopy (TEM-EDX), a scanning electron microscopy energy-dispersive X-ray spectroscopy (SEM-EDX), a X-ray fluorescence (XRF), or a combination thereof).

In an embodiment, a semiconductor nanoparticle includes indium, phosphorus, zinc, selenium, and sulfur, and the semiconductor nanoparticle includes a semiconductor nanocrystal layer including a zinc sulfide, and the semiconductor nanoparticle may be configured to emit green light. The semiconductor nanoparticle does not include cadmium. The semiconductor nanoparticle may have the structure and properties described herein.

In the semiconductor nanoparticle or the light-emitting layer including the semiconductor nanoparticles, a mole ratio of zinc to indium (Zn:In) may be greater than or equal to about 39:1, greater than or equal to about 40:1, greater than or equal to about 41:1, greater than or equal to about 42:1, greater than or equal to about 43:1, greater than or equal to about 44:1, greater than or equal to about 45:1, greater than or equal to about 46:1, greater than or equal to about 47:1, greater than or equal to about 48:1, greater than or equal to about 49:1, greater than or equal to about 50:1, greater than or equal to about 51:1, greater than or equal to about 52:1, greater than or equal to about 53:1, greater than or equal to about 54:1, greater than or equal to about 55:1, greater than or equal to about 56:1, greater than or equal to about 57:1, greater than or equal to about 58:1, greater than or equal to about 59:1, greater than or equal to about 60:1, greater than or equal to about 61:1, greater than or equal to about 62:1, greater than or equal to about 63:1, greater than or equal to about 64:1, greater than or equal to about 65:1, or greater than or equal to about 66:1. In the semiconductor nanoparticle or the light-emitting layer including the semiconductor nanoparticles, a mole ratio of zinc to indium (Zn:In) may be greater than or equal to about 60:1, greater than or equal to about 67:1, greater than or equal to about 68:1, greater than or equal to about 69:1, greater than or equal to about 70:1, greater than or equal to about 71:1, greater than or equal to about 72:1, greater than or equal to about 73:1, greater than or equal to about 74:1, greater than or equal to about 75:1, greater than or equal to about 76:1, greater than or equal to about 77:1, greater than or equal to about 78:1, greater than or equal to about 79:1, or greater than or equal to about 80:1.

The mole ratio of zinc to indium may be less than or equal to about 250:1, less than or equal to about 240:1, less than or equal to about 230:1, less than or equal to about 220:1, less than or equal to about 210:1, less than or equal to about 200:1, less than or equal to about 190:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 105:1, less than or equal to about 100:1, less than or equal to about 95:1, less than or equal to about 92:1, less than or equal to about 91:1, less than or equal to about 90:1, less than or equal to about 89:1, less than or equal to about 85:1, less than or equal to about 80:1, less than or equal to about 75:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, or less than or equal to about 59:1. In an embodiment, the mole ratio of zinc to indium may be from about 60:1 to about 250:1, from about 67:1 to about 230:1, from about 70:1 to about 200:1, from about 75:1 to about 150:1, from about 77:1 to about 130:1, from about 80:1 to about 125:1, from about 90:1 to about 110:1, from about 95:1 to about 107:1, from about 100:1 to about 105:1, or a combination thereof.

In an embodiment, in the semiconductor nanoparticle or the light-emitting layer including the semiconductor nanoparticles, a mole ratio of selenium to indium (Se:In) may be greater than or equal to about 25:1, greater than or equal to about 29:1, greater than or equal to about 30:1, greater than or equal to about 35:1, greater than or equal to about 37:1, greater than or equal to about 38:1, greater than or equal to about 39:1, greater than or equal to about 40:1, greater than or equal to about 41:1, greater than or equal to about 42:1, greater than or equal to about 43:1, greater than or equal to about 44:1, greater than or equal to about 45:1, greater than or equal to about 46:1, greater than or equal to about 47:1, greater than or equal to about 48:1, greater than or equal to about 49:1, greater than or equal to about 50:1, greater than or equal to about 51:1, greater than or equal to about 53:1, greater than or equal to about 57:1, greater than or equal to about 59:1, greater than or equal to about 60:1, greater than or equal to about 61:1, greater than or equal to about 63:1, greater than or equal to about 65:1, greater than or equal to about 67:1, greater than or equal to about 69:1, or greater than or equal to about 70:1. The mole ratio of selenium to indium may be less than or equal to about 200:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 100:1, less than or equal to about 90:1, less than or equal to about 80:1, less than or equal to about 75:1, less than or equal to about 74:1, less than or equal to about 73:1, less than or equal to about 72:1, less than or equal to about 71:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, less than or equal to about 59:1, less than or equal to about 58:1, less than or equal to about 57:1, less than or equal to about 56:1, less than or equal to about 55:1, less than or equal to about 54:1, less than or equal to about 53:1, or less than or equal to about 52:1.

In an embodiment, in the semiconductor nanoparticle or the light-emitting layer including the semiconductor nanoparticles, a mole ratio of sulfur to indium (S:In) may be greater than or equal to about 11.2:1, greater than or equal to about 11.5:1, greater than or equal to about 12:1, greater than or equal to about 13:1, greater than or equal to about 14:1, greater than or equal to about 15:1, greater than or equal to about 16:1, greater than or equal to about 17:1, greater than or equal to about 18:1, greater than or equal to about 19:1, greater than or equal to about 20:1, greater than or equal to about 21:1, greater than or equal to about 22:1, greater than or equal to about 23:1, greater than or equal to about 24:1, or greater than or equal to about 25:1. The mole ratio of sulfur to indium (S:In) may be less than or equal to about 50:1, less than or equal to about 45:1, less than or equal to about 40:1, less than or equal to about 35:1, less than or equal to about 30:1, less than or equal to about 25:1, less than or equal to about 20:1, less than or equal to about 19:1, less than or equal to about 18:1, less than or equal to about 17:1, less than or equal to about 16:1, less than or equal to about 15:1, or less than or equal to about 14:1.

In an embodiment, in the semiconductor nanoparticle or the light-emitting layer including the semiconductor nanoparticles, the mole ratio of the sum of sulfur and selenium relative to indium [(S+Se):In] may be greater than or equal to about 50:1, greater than or equal to about 55:1, greater than or equal to about 60:1, greater than or equal to about 61:1, greater than or equal to about 63:1, greater than or equal to about 65:1, greater than or equal to about 67:1, greater than or equal to about 69:1, greater than or equal to about 70:1, greater than or equal to about 71:1, greater than or equal to about 73:1, greater than or equal to about 75:1, greater than or equal to about 77:1, greater than or equal to about 79:1, greater than or equal to about 81:1, greater than or equal to about 83:1, greater than or equal to about 85:1, greater than or equal to about 87:1, greater than or equal to about 89:1, greater than or equal to about 90:1, greater than or equal to about 91:1, greater than or equal to about 93:1, greater than or equal to about 95:1, greater than or equal to about 97:1, greater than or equal to about 99:1, or greater than or equal to about 100:1.

In an embodiment, in the semiconductor nanoparticle or the light-emitting layer including the semiconductor nanoparticles, the mole ratio of the sum of sulfur and selenium to indium [(S+Se): In] may be less than or equal to about 250:1, less than or equal to about 230:1, less than or equal to about 210:1, less than or equal to about 200:1, less than or equal to about 190:1, less than or equal to about 180:1, less than or equal to about 170:1, less than or equal to about 160:1, less than or equal to about 150:1, less than or equal to about 140:1, less than or equal to about 130:1, less than or equal to about 120:1, less than or equal to about 110:1, less than or equal to about 100:1, less than or equal to about 90:1, less than or equal to about 85:1, less than or equal to about 80:1, less than or equal to about 75:1, or less than or equal to about 70:1.

In an embodiment, in the semiconductor nanoparticle or the light-emitting layer including the semiconductor nanoparticles, a mole ratio of indium to the sum of selenium and sulfur [In:(Se+S)] may be less than or equal to about 0.05:1, less than or equal to about 0.03:1, less than or equal to about 0.02:1, less than or equal to about 0.015:1, less than or equal to about 0.01:1, less than or equal to about 0.009:1, or less than or equal to about 0.008:1. The mole ratio of indium to the sum of selenium and sulfur [In:(Se+S)] may be greater than or equal to about 0.0005:1, greater than or equal to about 0.001:1, greater than or equal to about 0.003:1, greater than or equal to about 0.005:1, or greater than or equal to about 0.01:1.

In an embodiment, in the semiconductor nanoparticle or in the light emitting layer, a mole ratio of zinc to the sum of selenium and sulfur [Zn:(Se+S)] may be less than or equal to about 2:1, less than or equal to about 1.9:1, less than or equal to about 1.8:1, less than or equal to about 1.7:1, less than or equal to about 1.6:1, less than or equal to about 1.5:1, less than or equal to about 1.4:1, less than or equal to about 1.3:1, less than or equal to about 1.2:1, less than or equal to about 1.19:1, less than or equal to about 1.18:1, less than or equal to about 1.17:1, less than or equal to about 1.16:1, less than or equal to about 1.15:1, less than or equal to about 1.14:1, less than or equal to about 1.13:1, less than or equal to about 1.12:1, or less than or equal to about 1.1:1. The mole ratio of zinc to the sum of selenium and sulfur [Zn:(Se+S)] may be greater than or equal to about 0.8:1, greater than or equal to about 0.9:1, greater than or equal to about 1:1, greater than or equal to about 1.05:1, greater than or equal to about 1.1:1, or greater than or equal to about 1.15:1.

In an embodiment, in the semiconductor nanoparticle or in the light-emitting layer, a mole ratio of sulfur to selenium (S:Se) may be less than or equal to about 0.5:1, less than or equal to about 0.49:1, less than or equal to about 0.48:1, less than or equal to about 0.47:1, less than or equal to about 0.46:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.38:1, less than or equal to about 0.37:1, less than or equal to about 0.36:1, less than or equal to about 0.35:1, less than or equal to about 0.34:1, less than or equal to about 0.33:1, or less than or equal to about 0.32:1. The mole ratio of sulfur to selenium (S:Se) may be greater than or equal to about 0.15:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, greater than or equal to about 0.26:1, greater than or equal to about 0.27:1, or greater than or equal to about 0.28:1.

In an embodiment, in the semiconductor nanoparticle or the light-emitting layer including the semiconductor nanoparticles, the mole ratio of selenium to the sum of sulfur and selenium [Se:(Se+S)] may be greater than or equal to about 0.69:1, greater than or equal to about 0.7:1, greater than or equal to about 0.71:1, greater than or equal to about 0.72:1, greater than or equal to about 0.73:1, greater than or equal to about 0.74:1, or greater than or equal to about 0.75:1.

In the semiconductor nanoparticles or the light-emitting layer including the semiconductor nanoparticles, a mole ratio of selenium to the total sum of sulfur and selenium [Se:(Se+S)] may be less than or equal to about 1:1, less than or equal to about 0.99:1, less than or equal to about 0.97:1, less than or equal to about 0.95:1, less than or equal to about 0.93:1, less than or equal to about 0.91:1, less than or equal to about 0.9:1, less than or equal to about 0.89:1, less than or equal to about 0.87:1, less than or equal to about 0.85:1, less than or equal to about 0.83:1, less than or equal to about 0.82:1, less than or equal to about 0.8:1, less than or equal to about 0.79:1, less than or equal to about 0.76:1, or less than or equal to about 0.74:1.

In the semiconductor nanoparticle or the light-emitting layer including the semiconductor nanoparticles, a mole ratio of sulfur to the sum of selenium and sulfur (S:(Se+S)) may be less than or equal to about 0.31:1, less than or equal to about 0.3:1, less than or equal to about 0.29:1, less than or equal to about 0.28:1, less than or equal to about 0.25:1, or less than or equal to about 0.2:1.

In an embodiment, in the semiconductor nanoparticles or the light-emitting layer including the semiconductor nanoparticles, the mole ratio of sulfur to the sum of selenium and sulfur (S:(Se+S)) may be greater than 0:1, greater than or equal to about 0.01:1, greater than or equal to about 0.03:1, greater than or equal to about 0.05:1, greater than or equal to about 0.07:1, greater than or equal to about 0.08:1, greater than or equal to about 0.1:1, greater than or equal to about 0.11:1, greater than or equal to about 0.13:1, greater than or equal to about 0.15:1, greater than or equal to about 0.17:1, greater than or equal to about 0.18:1, greater than or equal to about 0.2:1, greater than or equal to about 0.21:1, greater than or equal to about 0.23:1, or greater than or equal to about 0.26:1.

In the semiconductor nanoparticles or the light-emitting layer including the semiconductor nanoparticles, the mole ratio of sulfur to selenium may be less than or equal to about 0.5:1.

A semiconductor nanoparticle-based electroluminescent device (hereinafter, can be referred to as a QD-LED) may emit light by the application of a voltage and may include a semiconductor nanocrystal particle as a light-emitting material. In a (photo)luminescent device including a light source, a semiconductor nanocrystal particle can be utilized as a wavelength conversion material that absorbs incident light emitted from a light source and emits light of a different spectrum e.g., having a peak emission wavelength lower than that of the incident light.

The QD-LED has been attracting an attention for a use in a next-generation display device as it can express a purer color (red, green, and blue) and a wider color gamut than an organic light emitting diodes (OLED), which uses a light emitting organic substance as an emission center. The QD-LED can be manufactured at a reduced manufacturing cost as its production may include a solution process, and since the device uses an inorganic-based material, the QD-LED may exhibit an increased stability. However, it is still desirable to develop a technology that can further improve a device performance and life span.

It is also desirable to provide a light-emitting device or a display device including a light-emitting layer that does not include a substantial amount of a harmful heavy metal. An electroluminescent device or a light emitting device according to an embodiment is a self-emission type electroluminescent device that is configured to emit a desired light, for example, by voltage application (e.g., with or without a separate light source).

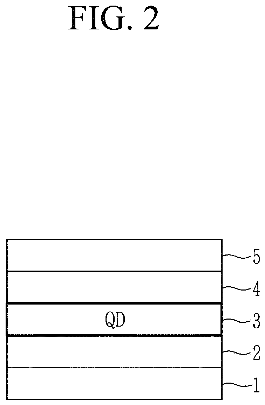

In an embodiment schematically represented in FIG. 2, an electroluminescent device includes a first electrode 1, a second electrode 5 (e.g., spaced from one another or facing each other), and a light-emitting layer 3 disposed between the first electrode and the second electrode. In an embodiment, a light emitting device of an embodiment may include a light source and a light emitting layer, wherein the light source is configured to provide the light emitting layer with incident light. The light-emitting layer includes a semiconductor nanoparticle described herein. The light emitting layer is configured to emit green light or blue light.

In an embodiment, an electron transport layer 4 may be disposed between the light-emitting layer 3 and the second electrode 5. The electroluminescent device may further include a hole auxiliary layer 2 between the light-emitting layer 3 and the first electrode 1. The electron auxiliary layer may be an electron transport layer. The hole auxiliary layer may include a hole transport layer (including, for example, an organic compound), a hole injection layer, or a combination thereof.

Details of the semiconductor nanoparticles are the same as described herein.

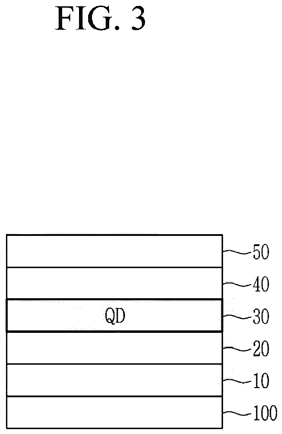

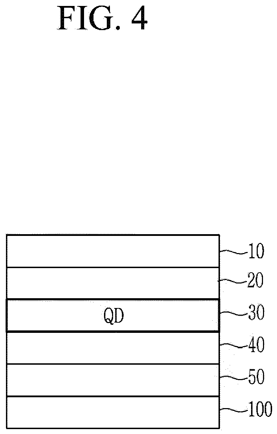

In electroluminescent device of an embodiment, the first electrode 10 or the second electrode 50 may each be disposed on a (transparent) substrate 100. The transparent substrate may be a light extraction surface. See, FIG. 3 and FIG. 4. Referring to FIGS. 3 and 4, the light-emitting layer 30 may be disposed between the first electrode 10 and the second electrode 50. The second electrode 50 may include an electron injection conductor. The first electrode 10 may include a hole injection conductor. The work functions of the electron/hole injection conductors included in the second electrode and the first electrode may be appropriately adjusted and are not particularly limited. For example, the second electrode may have a small work function and the first electrode may have a relatively large work function, or vice versa.

The electron/hole injection conductors (e.g., second electrode or first electrode) may include a metal-based material (e.g., a metal, a metal compound, an alloy, or a combination thereof) (aluminum, magnesium, tungsten, nickel, cobalt, platinum, palladium, calcium, or LiF), a metal oxide such as gallium indium oxide or indium tin oxide (ITO), or a conductive polymer (e.g., having a relatively high work function) such as polyethylene dioxythiophene, but are not limited thereto.

The first electrode, the second electrode, or a combination thereof, may be a light-transmitting electrode or a transparent electrode. In an embodiment, both the first electrode and the second electrode may be the light-transmitting electrode. The electrode may be patterned. The first electrode, the second electrode, or a combination thereof, may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may further include a region for a blue pixel, a region for a red pixel, a region for a green pixel, or a combination thereof. A thin film transistor may be disposed in each of the stated regions of the substrate, and one of a source electrode and a drain electrode of the thin film transistor may be electrically connected to the first electrode or the second electrode.

The light-transmitting electrode may be disposed on a (e.g., insulating) transparent substrate. The substrate may be rigid or flexible substrate. Accordingly, the substrate may be plastic, glass, or a metal.

The light transmittance of the light transmitting electrode may be in a range of greater than or equal to about 50%, greater than or equal to about 60%, greater than or equal to about 70%, greater than or equal to about 80%, greater than or equal to about 80%, or greater than or equal to about 90%, e.g., from about 80% to about 100%, from about 85% to about 95%, or a combination thereof.

The light-transmitting electrode may include, for example, a transparent conductor such as indium tin oxide (ITO) or indium zinc oxide (IZO), gallium indium tin oxide, zinc indium tin oxide, titanium nitride, polyaniline, or LiF/Mg:Ag, or a metal thin film of a single layer or a plurality of layers, but is not limited thereto. When one of the first electrode and the second electrode is an opaque electrode, the opaque electrode may be made of an opaque conductor such as aluminum (Al), a lithium-aluminum (Li:Al) alloy, a magnesium-silver alloy (Mg:Ag), or lithium fluoride-aluminum (LiF:Al). In an embodiment, the electrode may be an alloy electrode including materials, a ratio between the materials can be adjusted appropriately, e.g., it may range from 1:0.1 to 1:10, 1:0.2 to 1:5, 1:0.3 to 1:3, or a combination thereof.

In an embodiment, the first electrode or the second electrode may be a multilayer electrode. In an embodiment, the first electrode (or anode) may be a multilayer electrode including electrode materials that is two or more layers, three or more layers, and 10 or less layers or 5 or less layers. In an embodiment, the second electrode (or cathode) may be a multilayer electrode including electrode material that is two or more layers, three or more layers, and 10 or less layers or 5 or less layers.

The multilayer electrode may include, for example, a light transmitting conductive material such as indium tin oxide, an opaque conductive material such as aluminum (or a reflective electrode material), or a combination thereof. In an embodiment, the electrode (e.g., an anode or cathode) may have a structure in which the opaque conductive material (or a reflective electrode material layer) is disposed between light transmitting conductive materials (e.g., a transparent conductive material layer). In an embodiment, the electrode (e.g., an anode or a cathode) may have a structure in which a light transmitting conductive material (e.g., a light transmitting conductive material layer) is disposed between the opaque conductive materials (or reflective electrode materials).

When voltage is applied between the first and second electrodes, the light-emitting layer can emit/extract light up and down by the electric field, and the light advancing to the reflective electrode can be reflected and emitted/extracted in the opposite direction.

In an embodiment, light can be emitted or extracted towards the cathode. In an embodiment, light can be emitted or extracted towards the anode.

A thickness of each electrode (e.g., the first electrode, or the second electrode) is not particularly limited and may be appropriately selected taking into consideration a device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

The method of formation of the electrode is not particularly limited and can be selected appropriately according to the material. In an embodiment, the electrode may be formed by deposition, coating, or a combination thereof, but is not limited thereto.

The light-emitting layer 3 or 30 is disposed between the first electrode 1 and the second electrode 5 of FIG. 2 (or e.g., the first electrode 10 and the second electrode 50 of FIGS. 3 and 4). The light-emitting layer includes a semiconductor nanoparticle. The light-emitting layer may include a monolayer of a plurality of semiconductor nanoparticles. The light-emitting layer may include two or more (e.g., three or more) and 10 or less monolayers of the semiconductor nanoparticles.

The light-emitting layer may be patterned. In an embodiment, the patterned light-emitting layer may include a blue light-emitting layer (e.g., disposed within a blue pixel in a display device to be described herein), a red light-emitting layer (e.g., disposed within a red pixel in a display device to be described herein), and a green light-emitting layer (e.g., disposed within a green pixel in a display device to be described herein), or a combination thereof. Each of the light-emitting layers may be (e.g., optically) separated from an adjacent light-emitting layer by a partition wall. In an embodiment, the partition wall such as a black matrix may be disposed between the different color emitting layers, e.g., red light-emitting layer, the green light-emitting layer, and the blue light-emitting layer. In an embodiment, the red light-emitting layer, the green light-emitting layer, and the blue light-emitting layer may each be optically isolated.

The light-emitting layer or the semiconductor nanoparticle may not include cadmium. The light-emitting layer or the semiconductor nanoparticle may not include mercury, lead, or a combination thereof.

Details of the semiconductor nanoparticle included in the light-emitting layer are described herein.

In the light-emitting device, the thickness of the light-emitting layer may be selected appropriately. In an embodiment, the light-emitting layer 3 or 30 may include a monolayer of quantum dots. In an embodiment, the light-emitting layer 3 or 30 may include a monolayer of quantum dots, e.g., one, greater than or equal to about two, greater than or equal to about three, greater than or equal to about four or more and 20 or less, 10 or less, 9 or less, 8 or less, 7 or less, or 6 or less, monolayers of quantum dots. The light-emitting layer 3 or 30 may have a thickness of greater than or equal to about 5 nm, for example, greater than or equal to about 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light-emitting layer 3 or 30 may have the thickness of, for example about 10 nm to about 150 nm, for example about 20 nm to about 100 nm, or for example about 30 nm to about 50 nm.

The forming of a light-emitting layer can be carried out by obtaining a composition including semiconductor nanoparticles (configured to emit a light of a desired wavelength) and applying or depositing the composition on a substrate or charge auxiliary layer in an appropriate manner (e.g., by spin coating, inkjet printing, etc.).

In an embodiment, the electroluminescent device may include a charge auxiliary layer (e.g., an electron auxiliary layer, a hole auxiliary layer, or a combination thereof) between the first electrode and the second electrode.

In an embodiment, the electroluminescent device may include a charge (hole or electronic) auxiliary layer between the first electrode and the second electrode (e.g., the anode and the cathode). In an embodiment, the electroluminescent device may include a hole auxiliary layer 20 and/or an electron auxiliary layer 40 between the first electrode 10 and the light-emitting layer 30 and/or between the second electrode 50 and the light-emitting layer 30. (see Fig. 3 and Fig. 4)

In an embodiment, the electroluminescent device may include a hole auxiliary layer. The hole auxiliary layer 20 may be located between the first electrode 10 and the light emitting layer 30. The hole auxiliary layer 20 may include a hole injection layer, a hole transport layer, and/or an electron barrier layer. The hole auxiliary layer 20 may be a single-component layer or a multi-layered structure in which adjacent layers include different components.

The HOMO energy level of the hole auxiliary layer 2 or 20 may be matched with the HOMO energy level of the light-emitting layer 3 or 30, so that the mobility of holes transferred from the hole auxiliary layer 2 or 20 to the light-emitting layer 3 or 30 may be enhanced. In an embodiment, the hole auxiliary layer 2 or 20 may include a hole injection layer proximate to the first electrode 1 or 10 and a hole transport layer proximate to the light-emitting layer 3 or 30.

A material of the hole auxiliary layer 2 or 20 (e.g., a hole transport layer or hole injection layer) is not particularly limited. In an embodiment, the material of the hole auxiliary layer may include poly(9,9-dioctyl-fluorene-co-N-(4-butylphenyl)-diphenylamine) (TFB), polyarylamine, poly(N-vinylcarbazole) (PVK), poly(3,4-ethylenedioxythiophene) (PEDOT), poly(3,4-ethylenedioxythiophene):polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), 4,4',4"-Tris[phenyl(m-tolyl)amino]triphenylamine (m-MTDATA), 4,4',4"-tris(N-carbazolyl)-triphenylamine (TCTA), 1,1-bis[(di-4-tolylamino)phenyl]cyclohexane (TAPC), p-type metal oxide (e.g., NiO, $WO_3$, $MoO_3$, etc.), a carbon-based material such as graphene oxide, or a combination thereof, but is not limited thereto.

The electron blocking layer (EBL) may include, for example, poly(3,4-ethylenedioxythiophene):poly(styrene sulfonate) (PEDOT:PSS), poly(9,9-dioctyl-fluorene-coN-(4-butylphenyl)-diphenylamine) (TFB), polyarylamine, poly(N-vinylcarbazole), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA, 4,4',4"-tris(N-carbazolyl)-triphenylamine (TCTA), or a combination thereof, but is not limited thereto.

In the hole auxiliary layer(s), a thickness of each layer may be selected appropriately. In an embodiment, the thickness of each layer may be greater than or equal to about 5 nm, greater than or equal to about 10 nm, greater than or equal to about 15 nm, or greater than or equal to about 20 nm and less than or equal to about 50 nm, less than or equal to about 40 nm, less than or equal to about 50 nm, less than or equal to about 35 nm, or less than or equal to about 30 nm, but is not limited thereto.

In an embodiment, the second electrode may be a cathode, and the electron auxiliary layer 4 or 40 may be disposed between the light-emitting layer 3 or 30 and the second electrode 5 or 50. The electron auxiliary layer 4 or 40 may include, for example, an electron injecting layer, an electron transporting layer, a hole blocking layer, or a combination thereof. The electron auxiliary layer may be, for example, an electron injecting layer (EIL) that facilitates electron injection, an electron transporting layer (ETL) that facilitates electron transport, a hole blocking layer (HBL) that blocks hole movement, or a combination thereof.

In an embodiment, an electron injecting layer may be disposed between the electron transport layer and the cathode. In an embodiment, a hole blocking layer may be disposed between the light-emitting layer and the electron transporting (injecting) layer, but is not limited thereto. The thickness of each layer may be appropriately selected. For example, the thickness of each layer may be greater than or equal to about 1 nm and less than or equal to about 500 nm but is not limited thereto. The electron injecting layer may be an organic layer formed by deposition. The electron transporting layer may include inorganic oxide nanoparticles or be an organic layer formed by deposition.

The electron transporting layer (ETL), the hole blocking layer (HBL), and/or the electron injection layer may include, for example, 1,4,5,8-naphthalene-tetracarboxylic dianhydride (NTCDA), bathocuproine (BCP), tris[3- (3-pyridyl)-mesityl]borane (3TPYMB), LiF, $Alq_3$, $Gaq_3$, $Inq_3$, $Znq_2$, $Zn(BTZ)_2$, $BeBq_2$, ET204 (8-(4-(4,6-di(naphthalen-2-yl)-1,3,5-triazin-2-yl)phenyl)quinolone), 8-hydroxyquinolinato lithium (Liq), n-type metal oxide (e.g., ZnO, or HfOz), or a combination thereof, but is not limited thereto.

The electronic auxiliary layer 4 or 40 may include an electron transport layer which includes a plurality of metal oxide nanoparticles. The nanoparticles may include a metal oxide including zinc.

The metal oxide may include a zinc oxide, a zinc magnesium oxide, or a combination thereof. The metal oxide may include $Zn_{1-x}M_xO$ (wherein, M is Mg, Ca, Zr, W, Li, Ti, Y, Al, Co, or a combination thereof, and $0 \leq x \leq 0.5$). In an embodiment, M may be magnesium (Mg). In an embodiment, x may be greater than or equal to about 0.01 and less than or equal to about 0.3, for example, less than or equal to about 0.25, less than or equal to about 0.2, or less than or equal to about 0.15.

In an embodiment, an absolute value of LUMO of the aforementioned semiconductor nanoparticle included in the light-emitting layer may be less than an absolute value of LUMO of the metal oxide. The metal oxide nanoparticles may have an average size of greater than or equal to about 1 nm, for example, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm.

In an embodiment, each thickness of the electron auxiliary layer 4 or 40 (e.g., an electron injecting layer, an electron transporting layer, or a hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device according to an embodiment may have a normal structure. In an embodiment, referring to FIG. 3, the device includes a first electrode 10 disposed on a transparent substrate 100, e.g., a metal oxide-based (i.e., metal oxide) transparent electrode (e.g., ITO electrode) and a second electrode 50 (e.g., facing the first electrode) may include a conductive metal (e.g., Mg, or Al) (e.g., having a relatively low work function). A hole auxiliary layer 20 (e.g., a hole injecting layer of, for example, PEDOT:PSS, p-type metal oxide, or a combination thereof; a hole transport layer of TFB, PVK, or a combination thereof; or a combination thereof) may be disposed between the first electrode 10 and the light-emitting layer 30. The hole injecting layer may be proximate to the first electrode and the hole transport layer may be proximate to the light-emitting layer. An electron auxiliary layer 40 such as an electron injecting layer/transporting layer may be disposed between the quantum dot light-emitting layer 30 and the second electrode 50.

In an embodiment, a device may have an inverted structure. For example, referring to FIG. 4, a second electrode 50 is disposed on a transparent substrate 100, e.g., a metal oxide-based transparent electrode (e.g., ITO) and a first electrode 10 may include a metal (e.g., Au, or Ag) (e.g., having a relatively high work function). For example, (optionally doped) n-type metal oxide (crystalline Zn metal oxide) may be disposed between the second electrode 50 and the light-emitting layer 30 as an electron auxiliary layer 40 (e.g., an electron transporting layer). A hole auxiliary layer 20 (e.g., a hole transport layer including TFB, PVK, or a combination thereof; a hole injecting layer including $MoO_3$ or other p-type metal oxides; or a combination thereof) may be disposed between the first electrode 10 and the quantum dot light-emitting layer 30.

The electroluminescent device of an embodiment may be prepared in an appropriate method. In an embodiment, the electroluminescent device may be prepared by providing a first (or second) electrical conductor, optionally forming a charge auxiliary layer thereon for example by depositing or coating, and forming a light-emitting layer including the aforementioned plurality of semiconductor nanoparticles (e.g., a pattern thereof), optionally provide a charge auxiliary layer, and providing a second (or a first) electrical conductor for example via deposition or coating.

The formation of the electrical conductor and the charge auxiliary layer (e.g., the hole auxiliary layer or the electron auxiliary layer) may be carried out appropriately and are not particularly limited.

In an embodiment, the electroluminescent device may exhibit improved luminous properties (e.g., improved electroluminescent properties) or a combination thereof. In an embodiment, the electroluminescent device may exhibit a maximum external quantum efficiency (max EQE) of greater than or equal to about 6%, greater than or equal to about 7%, greater than or equal to about 8%, greater than or equal to about 9%, greater than or equal to about 9.5%, greater than or equal to about 10%, greater than or equal to about 10.2%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. In an aspect, the electroluminescent device may exhibit a maximum EQE in a range from about 6% to about 50%, from about 7% to about 40%, from about 8% to about 30%, from about 9% to about 20%, or a combination thereof.

In an embodiment, the electroluminescent device may exhibit a maximum luminance (max luminance) of greater than or equal to about 50,000 candelas per square meter ($cd/m^2$), greater than or equal to about 60,000 nits, greater than or equal to about 70,000 nits, greater than or equal to about 80,000 nits, greater than or equal to about 88,000 nits, greater than or equal to about 90,000 nits, greater than or equal to about 95,000 nits, greater than or equal to about 100,000 nits, greater than or equal to about 105,000 nits, greater than or equal to about 110,000 nits, greater than or equal to about 115,000 nits, greater than or equal to about 120,000 nits, greater than or equal to about or 125,000 nits.

The electroluminescent device may exhibit the aforementioned max EQE and the aforementioned max luminance.

The electroluminescent device may exhibit relatively improved lifespan properties. In an embodiment, as measured at being operated at a predetermined initial luminance, e.g., of about 146 nits(candelas per square meter, cd/m$^2$), about 650 nits, or about 2700 nit, the electroluminescent device may exhibit a T50 of greater than or equal to about 150 hours, greater than or equal to about 300 hours, greater than or equal to about 310 hours, greater than or equal to about 350 hours, greater than or equal to about 380 hours, greater than or equal to about 400 hours, greater than or equal to about 450 hours, or greater than or equal to about 500 hours. In an embodiment, as measured at being operated at a predetermined initial luminance, e.g., of about 146 nits(candelas per square meter, cd/m$^2$), about 650 nits, or about 2700 nit, the electroluminescent device may exhibit a T90 that is greater than or equal to about 20 hours, greater than or equal to about 30 hours, greater than or equal to about 45 hours, greater than or equal to about 50 hours, greater than or equal to about 75 hours, greater than or equal to about 100 hours, greater than or equal to about 125 hours, greater than or equal to about 150 hours, greater than or equal to about 175 hours, or greater than or equal to about 200 hours.

In an embodiment, the T50 may be from about 150 to 5000 hours, from about 200 to 300 hours, from about 400 to 4000 hours, from about 450 to 600 hours, from about 500 to 3500 hours, from about 750 hours to 2000 hours, from about 1000 to 1500 hours, or a combination thereof.

In an embodiment, the T90 may range from about 30 to 2500 hours, from about 45 hours to 2000 hours, from about 50 hours to 1500 hours, from about 75 hours to 1000 hours, from about 100 hours to 800 hours, from about 150 hours to 700 hours, from about 200 hours to 500 hours, from about 300 hours to 400 hours, or a combination thereof.

In an embodiment, a display device including the electroluminescent device described herein.

The display device may include a first pixel and a second pixel that is configured to emit light different from the first pixel. The first pixel, the second pixel, or a combination thereof, may include the electroluminescent device of an embodiment. The display device may include an AR/VR device, a mobile device, a monitor, a laptop, a television, an electronic sign, a camera, or an electronic component (for example, for a vehicle).

Hereinafter, specific embodiments of the present invention are presented. However, the examples described below are only for specifically illustrating or explaining the invention, and thus the scope of the invention should not be limited.

Examples

Analysis Method

1. Photoluminescence Analysis and Absolute Quantum Yield (QY) measurement

A photoluminescence spectroscopy analysis of the semiconductor nanoparticles was performed using a Hitachi F-7000 spectrometer or a Hamamatsu instrument at room temperature with irradiation of light having a wavelength of 400 nm (for a blue light emitting semiconductor nanoparticle).

2. Transmission Electron Microscopy (TEM) Analysis

A transmission electron micrography image of the semiconductor nanoparticle as prepared was obtained by using the UT F30 Tecnai electron microscope.

With Image J program or with an inhouse software based on the Python language, the obtained TEM image was analyzed to measure the particle size and shape factor.

3. Inductively Coupled Plasma (ICP) Analysis

An inductively coupled plasma-atomic emission spectroscopy (ICP-AES) analysis was performed using Shimadzu ICPS-8100.

4. Electroluminescence measurement

With the application of a voltage, a voltage-dependent current was measured with a Keithley 2635B source meter and an electro-luminance was measured using a CS2000 spectrometer.

5. Lifespan evaluation

For the T50 (hour), the time it took for a device to reach the 50% of an initial luminance(or an optical current density) (100%) as the device began to be driven at a predetermined luminance (e.g., 650 nit) was measured.

For the T90(h), the time it took for a device to reach the 90% of an initial luminance(or an optical current density) (100%) as the device began to be driven at a predetermined luminance (e.g., 650 nit) was measured.

6. TGA analysis

TGA analysis was conducted in a nitrogen ($N_2$) atmosphere using Discovery TGA (from TA instruments) at heating rate of 10 degrees Celsius/min from 30 degrees Celsius to 600 degrees Celsius.

7. GC Analysis

GC-MS analysis was performed using a Gas Chromatograph (GC, Agilent 7890B) coupled to a Mass Spectrometer (MS, Agilent 5977A).

After separation using ethanol, 1mL of the Crude dispersion containing the prepared semiconductor nanoparticles was vacuum-dried, and the semiconductor nanoparticle 0.1 mg and TMAH (trimethyl ammonium hydroxide) 1 uL (microliter) was mixed, kept in the hood, for 2 min, followed by py-GC/MS measurement.

- Pyrolyzer: 450 °C
- Column : 30m X 0.25mm X 0.25 mm (UA5)
- Flow : He (1 mL/min)
- Inlet temperature : 300 °C
- Analyzer : quadrupole (range : 10 to 550 m/z)

The following synthesis was performed under an inert gas atmosphere (e.g., under nitrogen) unless otherwise specified. A precursor content provided is as a molar content, unless otherwise specified.

Refernece Example: Synthesis of ZnMgO Nanoparticles

Zinc acetate dihydrate and magnesium acetate tetrahydrate are added to a reactor containing dimethylsulfoxide and heated at 60 °C in air. Subsequently, an ethanol solution of tetramethylammonium hydroxide pentahydrate is added to the reactor. After stirring the mixture for 1 hour, a precipitate form and is separated from the reaction mixture with a centrifuge. The precipitate is dispersed in ethanol to obtain $Zn_{1-x}Mg_xO$ nanoparticles. (x = 0.15) The obtained nanoparticles are subjected to a transmission electron microscope analysis. The particles have an average size of about 3 nm

Synthesis Example 1-1:

[1] Synthesis of first semiconductor nanocrystals:

Selenium and tellurium were dispersed in trioctylphosphine (TOP) to obtain a 2 molar (M) Se/TOP stock solution, and a 0.1 M Te/TOP stock solution, respectively.

In a 300 mL reaction flask containing trioctylamine (TOA), 4.5 mmol of zinc acetate was added with oleic acid and heated to 120 degrees Celsius under vacuum. After 1 hour, the atmosphere in the reactor was converted into an inert gas, e.g. nitrogen gas was added to the previously evacuated reaction flask.

The flask was heated to a reaction temperature (300°C), the prepared Se/TOP stock solution and Te/TOP stock solution were injected at a mole ratio of Te:Se of 1:15, and the reaction was allowed to proceed for a predetermined time (e.g. about an hour) after reaching the reaction temperature. Upon completion of the reaction, the reaction solution was cooled to room temperature and ethanol was added to promote precipitation. The resulting mixture was subjected to centrifugation to separate and obtain a ZnSeTe core, which was dispersed in hexane. The average size of the core was about 3 nm.

[2] Synthesis of a second semiconductor nanocrystal:

To 300 mL of reaction flask containing TOA, zinc acetate was added together with oleic acid and the resulting mixture was heated at 120°C under vacuum. Nitrogen ($N_2$) was added to the previously evacuated reaction flask and during the time period when the flask was heated to a reaction temperature (280°C), the hexane dispersion of the ZnSeTe core (above) was added to the reaction flask and then a Se/TOP stock solution was added. Upon the temperature of the flask reaching the reaction temperature, the reaction proceeded for a predetermined time (e.g. about an hour). Upon completion of the reaction, the reaction solution was cooled to room temperature and ethanol was added to promote precipitation. The resulting mixture was subjected to centrifugation to separate and to obtain a first particle (including the first semiconductor nanocrystal and the second semiconductor nanocrystal). The first particle thus obtained was dispersed in toluene and then washed with ethanol. The washed first particle was separated by centrifugation and dispersed in hexane.

[3] Formation of a semiconductor nanocrystal layer:

Zinc acetate was added together with oleic acid to a 300 mL reaction flask containing TOA, and the reaction mixture was vacuum-treated at 120°C to obtain a zinc precursor.

In a separate 300 mL reaction flask containing TOA the flask was vacuum-treated at 120°C. Nitrogen ($N_2$) was added to the previously evacuated reaction flask, and the flask was heated to 220°C (first temperature). The zinc precursor, the hexane dispersion of the first particles, and dodecanethiol as a sulfur precursor were added to the flask, and the flask was heated to 340°C and the reaction was allowed to proceed for 60 minutes.

The amount of dodecanethiol used was 0.5 mol per 1 mol of the zinc precursor.

Upon completion of the reaction, the reaction solution was cooled to room temperature, and ethanol was added thereto to promote precipitation. The resulting mixture was subjected to centrifugation to separate and to obtain semiconductor nanoparticles.

An ICP-AES analysis of the obtained semiconductor nanoparticles was performed and the results are shown in Table 1. A TEM analysis, a photoluminescence analysis, and a TGA analysis of the obtained semiconductor nanoparticle were performed, and the results are listed in Tables 2 and 4.

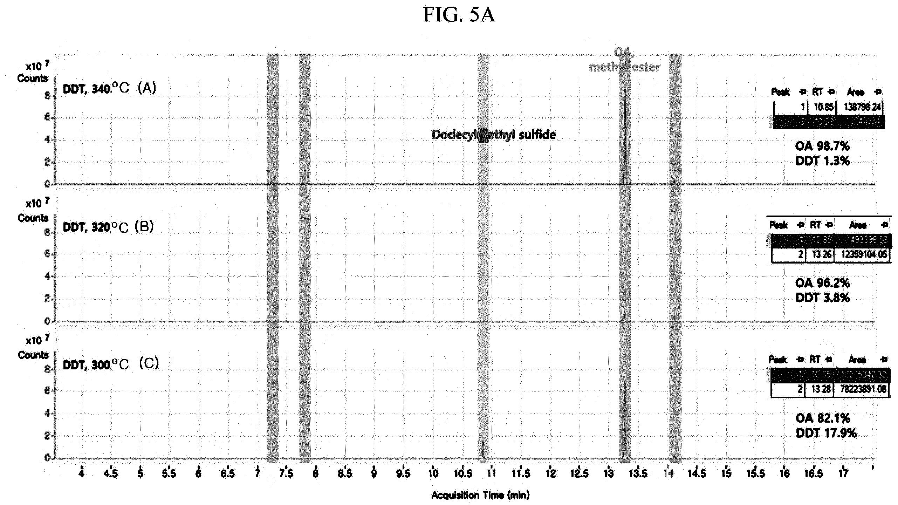

A GC-MS analysis of the obtained semiconductor nanoparticles was performed, and the results are summarized in Table 3 and FIG. 5A.

Synthesis Example 1-2:

The semiconductor nanoparticles were prepared in the same manner as in Synthesis Example 1-1, except that the reaction temperature was set to 320°C during the formation of the semiconductor nanocrystal layer. A GC-MS analysis of the obtained semiconductor nanoparticles was performed and the results are listed in Table 3 and FIG. 5A.

Synthesis Example 2:

The semiconductor nanoparticles were prepared in the same manner as in Synthesis Example 1-1, except that the preparation and the use of the zinc precursor for the semiconductor nanocrystal layer was conducted as follows: zinc acetate together with oleic acid was added to a 300 mL reaction flask containing TOA, which was vacuum-treated at 120°C to obtain zinc oleate (ZnOa), and in the similar manner, zinc ethylhexylate (Zn-EHa) was obtained using ethylhexyl acid and the obtained two types of the zinc precursors were used together at a mole ratio of ZnOa:Zn-EHa of 21:4.

An ICP-AES analysis of the obtained semiconductor nanoparticles was performed and the results are shown in Table 1. A TEM analysis, a photoluminescence analysis, and a TGA analysis of the obtained semiconductor nanoparticle were performed, and the results are listed in Tables 2 and 4.

Comparative Synthesis Example 1:

The semiconductor nanoparticles were prepared in the same manner as in Synthesis Example 1-1, except that instead of dodecanethiol, S/TOP (1M) was used as a sulfur precursor.

An ICP-AES analysis of the obtained semiconductor nanoparticles was performed and the results are shown in Table 1. A TEM analysis, a photoluminescence analysis, and a TGA analysis of the obtained semiconductor nanoparticle were performed, and the results are listed in Tables 2 and 4.

Comparative Synthesis Examples 2-1 and 2-2:

The semiconductor nanoparticles were prepared in the same manner as in Synthesis Example 1-1, except that in the formation of the semiconductor nanocrystal layer, the reaction temperature was set to 280°C and 0.8 mol of S/TOP was additionally injected per 1 mol of Zn (Comp. Synthesis Example 2-1) and the reaction temperature was set to 300 °C (for Comp. Synthesis Example 2-2).

A GC-MS analysis of the obtained semiconductor nanoparticles was performed, and the results are summarized in Table 3 and FIG. 5A.

Comparative Synthesis Example 3:

The semiconductor nanoparticles were prepared in the same manner as in Synthesis Example 1-1, except that in the formation of the semiconductor nanocrystal layer, the reaction temperature was set to 280°C.

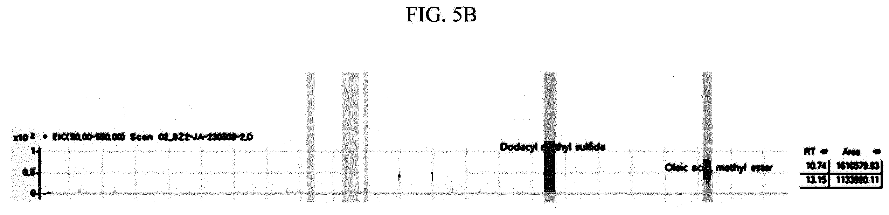

A GC-MS analysis of the obtained semiconductor nanoparticles was performed, and the results are summarized in Table 3 and FIG. 5B.

Comparative Synthesis Example 4:

The semiconductor nanoparticles were prepared in the same manner as in Synthesis Example 1-1, except that in the formation of the semiconductor nanocrystal layer, the sulfur precursor, i.e., the dodecanethiol was added only after the temperature in the reaction flask reached a reaction temperature of 320 °C - not at the first temperature. It was confirmed that the ZnS shell layer did not form appropriately resulting in semiconductor nanoparticles having relatively deficient properties.

Table 1

|  | S:(S+Se) | S:Te | Zn:Se | (S+Se):Zn |
|---|---|---|---|---|
| Comparative Synthesis Example 1 | 0.33:1 | 73:1 | 1.84:1 | 0.81:1 |
| Synthesis Example 1-1 | 0.44:1 | 107:1 | 1.83:1 | 0.97:1 |
| Synthesis Example 2 | 0.38:1 | 90:1 | 1.77:1 | 0.91:1 |

Table 2

|  | PWL (nm) | QY | FWHM | TGA organic amount (wt%) |
|---|---|---|---|---|
| Comparative Synthesis Example 1 | 462 | 96 | 45 | 14.8 |
| Synthesis Example 1-1 | 462 | 96 | 42 | 12.57 |
| Synthesis Example 2 | 460 | 91 | 41 | 10.184 |
| PWL: peak emission wavelength<br>QY: Quantum yield (%)<br>FWHM: Full width at half maximum (nm)<br>TGA organic amount: the amount of the organic matter of the semiconductor nanoparticle as measured in a thermogravimetric analysis. | | | | |

The results of Table 2 indicate that the semiconductor nanoparticles of Synthesis Example 1-1 and Synthesis Example 2 have a reduced organic material content compared to the semiconductor nanoparticles of Comparative Synthesis Example 1.

Table 3

|  | OA | DDT |
|---|---|---|
| Comparative Synthesis Example 2-1 | 25.2% | 74.8% |
| Comparative Synthesis Example 2-2 | 82.1% | 17.9% |
| Comparative Synthesis Example 3 | 41.3% | 58.7% |
| Synthesis Example 1-1 | 98.7% | 1.3% |
| Synthesis Example 1-2 | 96.2% | 3.8% |
| OA: Area percentage of the peak for the oleate ligand (first ligand) with respect to a total area of peaks for the ligands derived from the oleate ligand (first ligand) and dodecanethiolate ligand (second ligand) (OA peak location: 13.15)<br>DDT: Area percentage of the peak for the thiolate ligand (second ligand) with respect to a total area of peaks for the ligands derived from the oleate ligand (first ligand) and dodecanethiolate ligand (second ligand) (DDT peak location: 10.74) | | |

The results of Figs. 5A, 5B, and Table 3 show that the semiconductor nanoparticles of Synthesis Example 1-1 and Synthesis Example 1-2 include the thiol-derived organic ligands and the oleic acid-derived organic ligands, though the amount of thiol-derived organic ligands is limited. In contrast, the semiconductor nanoparticles of Comparative Synthesis Examples 2-1, 2-2, and 3 contains a significantly greater amount of the thiol-derived organic ligands.

Table 4

|  | average size (diameter) (nm) | circularity | roundness | solidity |
|---|---|---|---|---|
| Comparative Synthesis Example 1 | 10.25 | 0.804 | 0.714 | 0.975 |
| Synthesis Example 1-1 | 9.74 | 0.836 | 0.754 | 0.981 |
| Synthesis Example 2-1 | 9.97 | 0.834 | 0.757 | 0.98 |

Synthesis Example 3:

The semiconductor nanoparticles were prepared in the same manner as in Synthesis Example 1-1, except that in the formation of the semiconductor nanocrystal layer, octane thiol (OT) was used as a sulfur precursor instead of the dodecane thiol.

Synthesis Example 4:

The semiconductor nanoparticles were prepared in the same manner as in Synthesis Example 1-1, except that in the formation of the semiconductor nanocrystal layer, 2-ehylhexanethiol (EHT) was used as a sulfur precursor instead of the dodecane thiol.

Synthesis Example 5:

The semiconductor nanoparticles were prepared in the same manner as in Synthesis Example 1-1, except that in the formation of the semiconductor nanocrystal layer, tetradecanethiol (TDT) was used as a sulfur precursor instead of the dodecane thiol.

Preparation of Electroluminescent Device

Device Example 1-1

The light-emitting device was fabricated using the plurality of semiconductor nanoparticles of Synthesis Example 1-1 according to the following method.
A poly(3,4-ethylenedioxythiophene)polystyrene sulfonate (PEDOT:PSS) solution (H.C. Starks) followed by a poly[(9,9-dioctylfluorene-co-(4,4'-(N-4-butylphenyl)diphenylamine] solution (TFB) (Sumitomo) were spin-coated on an indium tin oxide (ITO) (anode)-deposited glass substrate, and then heat-treated to provide a hole injecting layer (HIL) with a thickness of 30 nm and a hole transporting layer (HTL) with a thickness of 25 nm, respectively.
The semiconductor nanoparticles obtained from Synthesis Example 1-1 were dispersed in octane and was spin-coated on the HTL and heat-treated to provide a light-emitting film with a thickness of 25 nm. An electron transporting layer (ETL) including $Zn_{1-x}Mg_xO$ nanoparticles prepared by the reference example was formed on the light-emitting film, the ETL having a thickness of about 28 nm. Then, aluminum (Al) was vacuum-deposited on the ETL to provide a second electrode.
It was confirmed that the obtained device emitted blue light upon application of a voltage. The electroluminescent properties of the obtained device were evaluated, and the results are listed in Table 5.

Device Example 1-2

A light-emitting device was fabricated in accordance with the same procedure as in Device Example 1-1, except for using the plurality of semiconductor nanoparticles of Synthesis Example 1-2, instead of the semiconductor nanoparticles of Synthesis Example 1-1 for the formation of the light-emitting film.
It was confirmed that the obtained device emitted blue light upon application of a voltage. The electroluminescent properties were measured for the obtained device, and the results are listed in Table 5.

Device Example 2

A light-emitting device was fabricated in accordance with the same procedure as in Device Example 1-1, except for using the plurality of semiconductor nanoparticles of Synthesis Example 2, instead of the semiconductor nanoparticles of Synthesis Example 1-1 for the formation of the light-emitting film.
It was confirmed that the obtained device emitted blue light upon application of a voltage. The electroluminescent properties were measured for the obtained device, and the results are listed in Table 5.

Comparative Device Example 1

A light-emitting device was fabricated in accordance with the same procedure as in Device Example 1-1, except for using the plurality of semiconductor nanoparticles of Comparative Synthesis Example 1, instead of the semiconductor nanoparticles of Synthesis Example 1-1 for the formation of the light-emitting film.
It was confirmed that the obtained device emitted blue light upon application of a voltage. The electroluminescent properties were measured for the obtained device, and the results are listed in Table 5.

Comparative Device Example 2

A light-emitting device was fabricated in accordance with the same procedure as in Device Example 1-1, except for using the plurality of semiconductor nanoparticles of Comparative Synthesis Example 2, instead of the semiconductor nanoparticles of Synthesis Example 1-1 for the formation of the light-emitting film.
It was confirmed that the obtained device emitted blue light upon application of a voltage. The electroluminescent properties were measured for the obtained device, and the results are listed in Table 5.

Table 5

|  | Max EQE % | Max Luminance cd/m$^2$ | T90 (hr) | T50 (hr) |
|---|---|---|---|---|
| Device Example 1-1 | 13.2 | 111210 | 43 | 179 |
| Device Example 1-2 | 13 | 87526 | 59 | 204 |
| Device Example 2 | about 12 | 95492 | 56 | 346 |
| Comp. Device Example 1 | about 12 | 85422 | 13 | 86 |
| Comp. Device Example 2-1 | about 12 | 62118 | 4.9 | 60 |
| Max EQE: Maximum external quantum efficiency (%) <br> Max Luminance: Maximum luminance (cd/m$^2$) | | | | |

The results of Table 5 confirm that the devices of the Examples exhibit significantly improved electroluminescent properties with an extended lifespan (stability) compared to the devices of the Comparative Examples.

Experimental Example 1 (Hole Only Device (HOD), HOD manufacturing)

A HOD was manufactured in the same manner as in Device Example 2 and Device Comparative Example 1, except that a hole auxiliary layer using a small molecule organic hole transport material (e.g., HAT-CN, etc.) was formed instead of the electron transport layer and the thickness of the quantum dot emission layer is 40 nm.
An experiment was conducted to measure the current while applying voltage to the manufactured HOD. The results for HOD are listed in Table 6.

Table 6

| Semiconductor nanoparticle in the light emitting layer of HOD | HOD 8V, 40 nm light emitting layer |
|---|---|
| Synthesis Example 2 | 4.73 mA/cm$^2$ |
| Comparative Synthesis Example 1 | 0.36 mA/cm$^2$ |

The results of Table 6 confirm that the semiconductor nanoparticles of Synthesis Example 2 exhibits improved hole transporting results compared to the semiconductor nanoparticles of Comparative Synthesis Example 1.

Device Example 3:

A light-emitting device was fabricated in accordance with the same procedure as in Device Example 1-1, except for using the plurality of semiconductor nanoparticles of Synthesis Example 3 (prepared using OT as a sulfur precursor), instead of the semiconductor nanoparticles of Synthesis Example 1-1 for the formation of the light-emitting film.

It was confirmed that the obtained device emitted blue light upon application of a voltage. The electroluminescent properties and the life span of the device were measured. The results confirmed that the maximum luminance of the device was 1.5 times and 2 times higher than Comparative Examples 1 and 2, respectively; T90 of the device was 2.75 times and 7.31 times longer than Comparative Examples 1 and 2, respectively; and T50 of the device was 1.62 times and 2.33 times longer than Comparative Examples 1 and 2, respectively.

Device Example 4

A light-emitting device was fabricated in accordance with the same procedure as in Device Example 1-1, except for using the plurality of semiconductor nanoparticles of Synthesis Example 4 (prepared using EHT as a sulfur precursor), instead of the semiconductor nanoparticles of Synthesis Example 1-1 for the formation of the light-emitting film.

It was confirmed that the obtained device emitted blue light upon application of a voltage. The electroluminescent properties and the life span of the device were measured. The results confirmed that the maximum luminance of the device was substantially equal to and 1.31 times higher than Comparative Examples 1 and 2, respectively; T90 of the device was 3.90 times and 10.35 times longer than Comparative Examples 1 and 2, respectively; and T50 of the device was 3.83 times and 5.49 times longer than Comparative Examples 1 and 2, respectively.

Device Example 5

A light-emitting device was fabricated in accordance with the same procedure as in Device Example 1-1, except for using the plurality of semiconductor nanoparticles of Synthesis Example 5 (using TDT as a sulfur precursor), instead of the semiconductor nanoparticles of Synthesis Example 1-1 for the formation of the light-emitting film.

It was confirmed that the obtained device emitted blue light upon application of a voltage. The maximum luminance and the life span of the device were measured. The results confirmed that the maximum luminance of the device was about 1.5 times and 2.1 times higher than Comparative Examples 1 and 2, respectively; T90 of the device was 3.36 times and 8.91 times longer than Comparative Examples 1 and 2, respectively; and T50 of the device was 1.69 times and 2.42 times longer than Comparative Examples 1 and 2, respectively.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

**Claims**

1. A method for preparing a semiconductor nanoparticle, which comprises:

    contacting a zinc precursor and a sulfur precursor in the presence of a first particle at a predetermined temperature to form a semiconductor nanocrystal layer containing zinc sulfide on the first particle, wherein the first particle comprises:

    a Group II-VI compound including zinc, selenium,
    wherein the predetermined temperature comprises a temperature of greater than 300 °C and less than or equal to 380 °C, and
    wherein the sulfur precursor comprises a thiol compound of C3 to C50 or a combination thereof.

2. The method of claim 1, wherein the sulfur precursor does not comprise a sulfur-trioctylamine (S-TOA), a sulfur-trioctyl phosphine (S-TOP), a sulfur-octadecene (S-ODE), or a combination thereof.

3. The method of claims 1 or 2, the first particle further comprises a Group III-V compound.

4. The method of any of claims 1-3, wherein the first particle comprises a first semiconductor nanocrystal and a second semiconductor nanocrystal,

the first semiconductor nanocrystal comprises a Group II-VI compound including zinc, selenium, and tellurium; or a Group III-V compound including indium and phosphorus, and/or
the second semiconductor nanocrystal comprises a Group II-VI compound including zinc and selenium.

5. The method of any of claims 1-4, wherein the method further comprises adding the first particle, the zinc precursor, and the sulfur precursor to a reaction medium including an organic solvent at a first temperature, the first temperature being greater than or equal 180 °C and less than 320 °C;
optionally wherein prior to being added to the reaction medium, the first particle is washed with an organic solvent and then be dispersed in a dispersing solvent.

6. The method of any of claims 1-5, wherein the predetermined temperature is greater than 335 °C and less than or equal to 360 °C; and/or
wherein the sulfur precursor comprises a ethylhexane thiol, decanethiol, undecane thiol, dodecane thiol, tetradecane thiol, hexadecane thiol, octadecane thiol, or a mixture thereof.

7. The method of any of claims 1-6, wherein the zinc precursor comprises a compound represented by Chemical Formula 1:

Chemical Formula 1        ACOO-Zn-OOCB

In Chemical Formula 1, A and B are the same or different, and each independently a substituted or unsubstituted, linear or branched, C1 to C60 aliphatic hydrocarbon group or a substituted or unsubstituted C3-C50 aromatic hydrocarbon group.

8. The method of any of claims 1-7, wherein in Chemical Formula 1, A and B are each independently a substituted or unsubstituted, C3-C40 branched, aliphatic hydrocarbon group, a substituted or unsubstituted, C10- C60 linear aliphatic hydrocarbon group, or a combination thereof; and/or
wherein the semiconductor nanoparticle comprises a first organic ligand including a carboxylate moiety of C12 or greater and a second organic ligand including a thiolate moiety, and in a GC-MS analysis, an area assigned to the second organic ligand is greater than or equal to 0.01% and less than or equal to 17% of a total area of peaks assigned to the first organic ligand and the second organic ligand.

9. A semiconductor nanoparticle comprising zinc, selenium, tellurium, and sulfur,

wherein the semiconductor nanoparticle does not comprise cadmium,
wherein the semiconductor nanoparticle is configured to emit blue light,
wherein the semiconductor nanoparticle has an absolute quantum yield of greater than or equal to 90%, and
wherein in the semiconductor nanoparticle, a mole ratio of zinc to selenium is greater than or equal to 1:1 and less than or equal to 3:1, and a mole ratio of sulfur to tellurium is greater than 73:1 and less than or equal to 180:1.

10. The semiconductor nanoparticle of claim 9, wherein the semiconductor nanoparticle comprises a first organic ligand including a carboxylate moiety of C12 or greater and a second organic ligand including a thiolate moiety, and in a GC-MS analysis, an area of peak assigned to the second organic ligand is greater than or equal to 0.01% and less than or equal to 17% of a total area of peaks assigned to the first organic ligand and the second organic ligand;
preferably wherein in the GC-MS analysis, the area of peak assigned to the second organic ligand is less than or equal to 4% of a total area of peaks assigned to the first organic ligand and the second organic ligand.

11. The semiconductor nanoparticle of claim 9 or 10,

wherein the blue light has a peak emission wavelength of greater than or equal to 450 nm and less than 480 nm;
wherein the semiconductor nanoparticle has a size of greater than or equal to 8 nm and less than or equal to 11 nm, and
wherein the semiconductor nanoparticle has a solidity of greater than or equal to 0.975.

12. The semiconductor nanoparticle of any of claims 9-11, wherein in the semiconductor nanoparticle,

a mole ratio of sulfur to tellurium (S:Te) is greater than or equal to 75:1 and than or equal to 130:1,
a mole ratio of zinc to selenium (Zn:Se) is greater than or equal to 1.5:1 and less than or equal to 1.9:1,

a mole ratio of sulfur to a sum of selenium and sulfur (S:(S+Se)) is greater than or equal to 0.3:1 and less than or equal to 0.5:1.

13. The semiconductor nanoparticle of any of claims 9-12, wherein the semiconductor nanoparticle has an absolute quantum yield of greater than or equal to 95%, and/or
wherein the semiconductor nanoparticle comprises a first semiconductor nanocrystal of $ZnTe_xSe_{1-x}$, wherein x is greater than or equal to about 0.005 and less than 0.04.

14. An electroluminescent device comprising:

a first electrode and a second electrode; and a light emitting layer disposed between the first electrode and the second electrode, the light emitting layer comprising a semiconductor nanoparticle of any of claims 9-13, and wherein the light emitting layer is configured to emit blue light;
preferably wherein the electroluminescent device is configured to exhibit a maximum external quantum efficiency of greater than or equal to 10% and wherein the electroluminescent device shows a T90 of greater than or equal to 20 hours as operated at an initial luminance of 650 nits.

15. A display device including the electroluminescent device of claim 14.

# FIG. 1

# FIG. 2

# FIG. 3

| | |
|---|---|
| | ~50 |
| | ~40 |
| QD | ~30 |
| | ~20 |
| | ~10 |
| | ~100 |

# FIG. 4

FIG. 5A

EP 4 497 801 A1

FIG. 5B

**EUROPEAN SEARCH REPORT**

Application Number

EP 24 19 0854

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 401 380 A1 (SAMSUNG ELECTRONICS CO LTD [KR]) 14 November 2018 (2018-11-14) * claims 1-15; examples * ----- | 1-15 | INV. C09K11/02 C09K11/88 |
| X | US 2019/280233 A1 (KIM TAE HYUNG [KR] ET AL) 12 September 2019 (2019-09-12) * claims 1-23; examples * ----- | 1-15 | |
| X | US 2023/096181 A1 (WON YUHO [KR] ET AL) 30 March 2023 (2023-03-30) * claims 1-21; examples * ----- | 1-15 | |

| | |
|---|---|
| | TECHNICAL FIELDS SEARCHED (IPC) |
| | C09K |

The present search report has been drawn up for all claims

| Place of search | Date of completion of the search | Examiner |
|---|---|---|
| The Hague | 29 November 2024 | Lehnert, Andreas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

..............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 0854

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2024

| Patent document cited in search report | | Publication date | Patent family member(s) | | Publication date |
|---|---|---|---|---|---|
| EP 3401380 | A1 | 14-11-2018 | CN | 108865109 A | 23-11-2018 |
| | | | EP | 3401380 A1 | 14-11-2018 |
| | | | KR | 20180124765 A | 21-11-2018 |
| | | | US | 2018327665 A1 | 15-11-2018 |
| | | | US | 2022220379 A1 | 14-07-2022 |
| | | | US | 2023392074 A1 | 07-12-2023 |
| US 2019280233 | A1 | 12-09-2019 | KR | 20190106825 A | 18-09-2019 |
| | | | US | 2019280233 A1 | 12-09-2019 |
| US 2023096181 | A1 | 30-03-2023 | KR | 20230044850 A | 04-04-2023 |
| | | | US | 2023096181 A1 | 30-03-2023 |

EPO FORM P0459

For more details about this annex : see Official Journal of the European Patent Office, No. 12/82